# EUROPÄISCHE PATENTSCHRIFT

(11) **EP 1 768 180 B1**
(45) Veröffentlichungstag und Bekanntmachung des Hinweises auf die Patenterteilung: **09.06.2010**
(21) Anmeldenummer: 06119368.6
(22) Anmeldetag: 23.08.2006
(51) Int. Cl.: H01L 23/522

(54) **Integrierte Schaltungsanordnung mit mehreren Leitstrukturlagen und Verfahren**
Integrated circuit with multiple conductor layer structures and method
Circuit intégré comprenant plusieurs structures de couches conductrices et procédé

(30) Priorität: 21.09.2005 DE 102005045060
(43) Veröffentlichungstag der Anmeldung: 28.03.2007
(73) Patentinhaber: Infineon Technologies AG, 85579 Neubiberg (DE)
(72) Erfinder: Schwerd, Markus, 83607, Holzkirchen (DE); Körner, Heinrich, 83052, Bruckmühl (DE); Hommel, Martina, 81739, München (DE); Seck, Martin, 81827, München (DE)
(74) Vertreter: Kindermann, Peter

(56) Entgegenhaltungen:
- WO-A-03/090283
- DE-A1- 10 012 700
- US-A- 5 227 659
- US-A1- 2005 104 157

## Beschreibung

Die Erfindung betrifft eine integrierte Schaltungsanordnung mit einem Substrat und mit mindestens drei direkt aufeinanderfolgenden Leitstrukturlagen. Das Substrat ist insbesondere ein einkristallines Halbleitersubstrat oder ein sogenanntes SOI-Substrat (Silicon On Insulator). Die Leitstrukturlagen werden auch als Metallisierungslagen bezeichnet, weil die in ihnen enthaltenen Leitstrukturen üblicherweise aus einem Metall oder aus einer Metalllegierung bestehen, beispielsweise aus einer Aluminiumlegierung, mit einem Aluminiumanteil größer als 60 Atomprozent oder größer als 90 Atomprozent Aluminium, oder aus einer Kupferlegierung, mit einem Kupferanteil größer als 60 Atomprozent oder größer als 90 Atomprozent. Jedoch sind auch andere Materialien für die Leitstrukturen geeignet, beispielsweise dotiertes Halbleitermaterial.

Bei den Leitstrukturen lassen sich Leitbahnen zum lateralen Stromtransport und sogenannte Vias bzw. Kontakte unterscheiden, die dem vertikalen Stromtransport dienen. Vertikal bezeichnet dabei eine Richtung, die in Richtung der Normalen einer Hauptfläche des Substrats liegt, in der auch integrierte Halbleiterbauelemente angeordnet sind. Alternativ bedeutet vertikal eine Richtung, die der Richtung der Normalen entgegengesetzt ist. Lateral bedeutet in einer Richtung, die quer bzw. im Winkel von 90° zu der Normalenrichtung liegt.

Die Leitstrukturlagen enthalten jeweils eine Vielzahl in einer Lage oder eine Ebene angeordnete Leitstrukturen. So erzeugen moderne Planarisierungsverfahren, wie beispielsweise das CMP-Verfahren (Chemisches Mechanisches Polieren), im Wesentlichen ebene Grenzflächen zwischen den Leitstrukturlagen. Von einer Leitstrukturlage kann jedoch auch dann gesprochen werden, wenn die Planarisierung im Rahmen der Herstellungstoleranzen nicht vollständig eben ist. Die einzelnen Lagen lassen sich voneinander durch andere strukturelle Merkmale unterscheiden, beispielsweise durch besondere Zwischenschichten zwischen Leitstrukturlagen oder durch spezifische Abstände der Lagenbodenflächen zu der Substrathauptfläche. Die Unterschiede der spezifischen Abstände für verschiedene Lagen sind dabei mindestens doppelt so groß oder mindestens dreimal so groß wie die Fertigungstoleranzen für die räumliche Lage der Bodenflächen der Leitstrukturlage in der die Leitbahnen mit diesen Bodenflächen angeordnet sind.

Die Leitstrukturen enthalten jeweils mindestens eine substratnahe Bodenfläche und eine substratferne Deckfläche. Eine Normalenrichtung der Bodenfläche liegt entgegen der Normalenrichtung der Substrathauptfläche. Eine Normalenrichtung der Deckfläche liegt in Richtung der Normalenrichtung der Substrathauptfläche, d.h. der Fläche, die die Halbleiterbauelemente enthält, beispielsweise Transistoren.

Die Deckflächen der Leitstrukturen einer der Leitstrukturlagen liegen jeweils in einer Lagendeckfläche der Leitstrukturlage. Die Lagendeckfläche ist beispielsweise eine Ebene. Die Bodenflächen der Leitstrukturen einer der Leitstrukturlagen liegen jeweils in einer Lagenbodenfläche der Leitstrukturlage. Die Lagenbodenfläche ist beispielsweise ebenfalls eine ebene Fläche. Abweichungen von einer ebenen Lagendeckfläche bzw. einer ebenen Lagenbodenfläche ergeben sich beispielsweise durch das Ineinandergreifen von Leitstrukturen benachbarter Leitstrukturlagen.

Zwischen der Lagendeckfläche und der Lagenbodenfläche einer Leitstrukturlage gibt es bspw. keine Zwischenfläche, in der Deckflächen oder Bodenflächen von Leitstrukturen dieser Leitstrukturlage angeordnet sind. Demzufolge sind insbesondere Leitstrukturen, die mit der dualen Damascene-Technik hergestellt sind, in verschiedenen Leitstrukturlagen angeordnet. Zur Herstellung von Leitstrukturlagen werden außerdem das einfache Damascene-Verfahren (Single Damascene) oder ein sogenanntes subtraktives Verfahren eingesetzt, bei dem aus der herzustellenden Leitstrukturlage beim Strukturieren elektrisch leitfähiges Material wieder entfernt wird, wie beispielsweise ein RIE-Verfahren (Reactive Ion Etching).

Die Lagen bzw. Ebenen, in denen die Leitstrukturen jeweils einer Leitstrukturlage angeordnet sind, liegen vorzugsweise parallel zu der Substrathauptfläche und damit auch parallel zueinander.

Typisch für bekannte Metallisierungen bzw. Verdrahtungen ist die abwechselnde Verwendung einer Via-Lage, die ausschließlich Vias enthält, und einer Leitbahnlage, die Leitbahnen und gegebenenfalls auch Vias bzw. sogenannte Landing Pads enthält. Diese Anordnung wird insbesondere in inneren Leitstrukturlagen der Schaltungsanordnungen ausschließlich verwendet.

Die US 2005/0104157 A1 betrifft Dreifachmetall- und Zwiefachmetallspulen. Eine zweite Metallschicht dient als Via verbindend zwei Metallverdrahtungen in anderen Bereichen des integrierten Schaltkreises, z.B., in Verdrahtungsbereichen. Aus der DE 100 12 700 A1 ist eine Halbleitervorrichtung mit einer vollständig abgeschirmten Abschirmleitung bekannt, die sich durch Mehrfachverdrahtungsebenen erstreckt. Aus der WO 03/090283 A2 ist ein Kondensator bekannt, der vertikal aneinander grenzende Platten mit Durchbrüchen und Vertikalelektroden innerhalb der Durchbrüche enthält.

Aus US 5 227 659 ist eine Spule bekannt, die sich über drei Metallisierungsebenen erstreckt.

Es ist Aufgabe der Erfindung, eine integrierte Schaltungsanordnung mit einer Metallisierung anzugeben, die verbesserte elektrische Eigenschaften hat und die insbesondere neue Anwendungsmöglichkeiten erschließt, z.B. die Herstellung von passiven Bauelementen mit besonders guten elektrischen Eigenschaften. Außerdem soll ein Verfahren zur Herstellung angegeben werden.

Die auf die Schaltungsanordnung bezogene Aufgabe wird durch eine Schaltungsanordnung mit den Merkmalen gemäß Anspruch 1 gelöst. Weiterbildungen sind in den Unteransprüchen angegeben.

Bei der erfindungsgemäßen Schaltungsanordnung gibt es mindestens drei unmittelbar aufeinanderfolgende Leitstrukturlagen, wobei jede der drei Leitstrukturlagen mindestens eine Verdrahtungs-Leitbahn oder eine Vielzahl von Verdrahtungs-Leitbahnen enthält. Eine Verdrahtungs-Leitbahn hat bei einer Ausgestaltung jeweils eine Länge, die mindestens fünfmal größer ist als eine Breite der Leitbahn. Sowohl die Länge als auch die Breite der Leitbahn werden in lateraler Richtung gemessen. Hat die Leitbahn entlang ihres Verlaufs unterschiedliche Breiten, so wird als Bezugsbreite beispielsweise die minimale Breite der Leitbahn an einem ihrer Abschnitte gewählt.

Durch die Verdrahtungs-Leitbahnen fließt im Betrieb der integrierten Schaltungsanordnung ein Strom, so dass sie sich von Füllstrukturen oder anderen Hilfsstrukturen der integrierten Schaltungsanordnung unterscheiden.

Bei der erfindungsgemäßen Schaltungsanordnung wird also keine Via-Lage zwischen zwei Verdrahtungs-Leitbahnlagen angeordnet. Auf diese Weise lassen sich auf einfache Art Spulen hoher Güte, Kondensatoren mit kleinem Anschlusswiderstand, Betriebsspannungsleitungen mit kleinem ohmschen Widerstand, Koaxialleitungen und andere passive Bauelemente erzeugen, wenn Leitbahnen benachbarter Leitstrukturlagen entlang ihrer gesamten Länge oder in einem längeren Abschnitt aneinandergrenzend angeordnet werden, beispielsweise in einem Abschnitt mit einer Länge, die zehn mal größer als die Breite des Abschnitts ist.

Außerdem hat die erfindungsgemäße Verdrahtung bei einer Ausgestaltung hervorragende elektrische Eigenschaften, wenn die drei Metallisierungslagen jeweils Leitbahnen enthalten, die im Vergleich zu ihrer Gesamtlänge nur an kurzen Abschnitten an Leitstrukturen anderer Metallisierungslagen angrenzen, z.B. nur an ihren Enden. Kurz bedeutet hierbei bspw. kleiner als ein Drittel oder sogar kleiner als ein Zehntel der Gesamtlänge der Leitbahn in der betreffenden Leiststrukturlage. Zwischen den Abschnitten liegt ein Abschnitt, der allseitig an Dielektrikum grenzt.

Bei der Ausgestaltung enthält die mittlere der drei Leitstrukturlagen eine mittlere Verdrahtungs-Leitbahn. Die substratfernste Leitstrukturlage der drei Leitstrukturlagen enthält eine substratferne Verdrahtungs-Leitbahn. Die substratnächste Leitstrukturlage der drei Leitstrukturlagen enthält eine substratnahe Verdrahtungs-Leitbahn. Die mittlere Verdrahtungs-Leitbahn, die substratferne Verdrahtungs-Leitbahn und die substratnahe Verdrahtungs-Leitbahn haben jeweils einen Abschnitt, dessen Deckfläche und dessen Bodenfläche nicht an eine Leitstruktur einer anderen Metallisierungslage grenzt. Der Abschnitt hat eine Länge, die mindestens die Breite oder das Zweifache der Breite des Abschnitts beträgt, vorzugsweise jedoch sogar das Zehnfache oder sogar das Fünfzigfache der Breite des Abschnitts. An den genannten Verdrahtungs-Leitbahnen ist jeweils eine der folgenden Anordnungen gegeben:
- an die Verdrahtungs-Leitbahn grenzen nur mindestens zwei Leitstrukturen der unmittelbar unter der betreffenden Leitstrukturlage angeordneten Leitstrukturlage, jedoch keine Leitstrukturen der darüber liegenden Leitstrukturlage,
- an die Verdrahtungs-Leitbahn grenzen nur mindestens zwei Leitstrukturen der unmittelbar darüber angeordneten Leitstrukturlage, jedoch keine Leitstrukturen der darunter liegenden Leitstrukturlage,
- an die Verdrahtungs-Leitbahn grenzt mindestens eine Leitstruktur der unmittelbar darunter angeordneten Leitstrukturlage und mindestens eine Leitstruktur der unmittelbar darüber angeordneten Leitstrukturlage.

Bei allen drei Möglichkeiten handelt es sich um Verdrahtungs-Leitbahnen, die jeweils eine Länge haben, die mindestens das Fünffache ihrer minimalen Breite beträgt. Die Verdrahtungs-Leitbahnen erstrecken sich bei Ausgestaltungen in die gleichen Richtungen. Bei anderen Ausführungsbeispielen erstreckt sich eine Leitbahn quer zu den anderen beiden der drei Leitbahnen, z.B. in x-Richtung, während die anderen beiden Leitbahnen sich in y-Richtung erstrecken. Die sich in die andere Richtung erstreckende Leitbahn ist bspw. die untere, die mittlere oder die obere der drei Leitbahnen.

Bei einer nächsten Ausgestaltung grenzt die mittlere Verdrahtungs-Leitbahn an die substratferne Verdrahtungs-Leitbahn und an die substratnahe Verdrahtungs-Leitbahn an Berührungsflächen an. Die Berührungsflächen sind mit lateralem Versatz zueinander angeordnet. Zwischen den Berührungsflächen befindet sich ein Abschnitt der mittleren Verdrahtungs-Leitbahn, der eine Deckfläche hat, die nicht an die substratferne Verdrahtungs-Leitbahn und auch nicht an eine andere substratferne Leitstruktur grenzt. Der Abschnitt der mittleren Verdrahtungs-Leitbahn hat eine Bodenfläche, die nicht an die substratnahe Verdrahtungs-Leitbahn und auch nicht an eine andere Leitstruktur grenzt. Der Abschnitt der mittleren Verdrahtungs-Leitbahn hat eine Länge, die mindestens die Breite oder das Zweifache der Breite des Abschnitts beträgt, vorzugsweise mehr als das Zehnfache. Ohne Verwendung von Vias lässt sich so auf einfache Art ein Stromtransport sowohl in vertikaler als auch in lateraler Richtung von der substratnahen Verdrahtungs-Leitbahn über die erste mittlere Leitbahn bis zur substratfernen Verdrahtungs-Leitbahn oder in umgekehrter Richtung gewährleisten.

Bei einer anderen Weiterbildung enthält die mittlere der drei Leitstrukturlagen mindestens eine mittlere Bauelement-Leitbahn zusätzlich zu der mittleren Verdrahtungs-Leitbahn. Die substratfernste Leitstrukturlage der drei Leitstrukturlagen enthält mindestens eine substratferne Bauelement-Leitbahn zusätzlich zu der substratfernen Verdrahtungs-Leitbahn. Die substratnächste Leitstrukturlage der drei Leitstrukturlagen enthält mindestens eine substratnahe Bauelement-Leitbahn zusätzlich zu der substratnahen Verdrahtungs-Leitbahn. Die mittlere Bauelement-Leitbahn grenzt in einem Bauelementabschnitt an die substratferne Bauelement-Leitbahn an. An dem Bauelementabschnitt grenzt die mittlere Bauelement-Leitbahn außerdem an die substratnahe Bauelement-Leitbahn an. Der Bauelementabschnitt hat eine Länge, die mindestens das Vierfache oder mindestens das Zehnfache oder sogar das Fünfzigfache der Breite des Bauelementabschnitts beträgt, bspw. der minimalen Breite. Mit solchen Strukturen lassen sich auf einfache Art und Weise passive Bauelemente herstellen, insbesondere Spulen hoher Güte, Koaxialleitungen oder auch Leitungen mit einem geringen ohmschen Widerstand aufgrund des großen Leitungsquerschnitts der parallel zueinander geführten Leitbahnen sowie vertikale Kondensatoren.

Die Damascene-Architektur erlaubt aus Kosten und Prozessgründen nur begrenzte Bahnquerschnitte (Breitenlimit durch sogenanntes Dishing, Dickenlimit aus kosten- und prozesstechnischen Gründen). Deswegen und weil Leitbahnebenen bisher über diskrete Vias verbunden worden sind, waren die erzielbaren physikalischen Parameter, z.B. die Güte einer Spule, weniger gut als bei Einsatz der Erfindung oder einer ihrer Weiterbildungen.

Bei einer nächsten Weiterbildung bestehen die Leitstrukturen jeder der drei Leitstrukturlagen jeweils aus Aluminium oder aus mindestens 60 Atomprozent Aluminium. Bei einer alternativen Weiterbildung bestehen die Leitstrukturen der drei Leitstrukturlagen jeweils aus Kupfer oder mindestens 60 Atomprozent Kupfer. Damit wird die Metallisierung aus Materialien gefertigt, deren Bearbeitung technologisch gut beherrscht wird.

Bei einer anderen Weiterbildung der erfindungsgemäßen Schaltungsanordnung sind die drei Leitstrukturlagen innere Leitstrukturlagen der Schaltungsanordnung. Diese Weiterbildung überwindet das Vorurteil, dass sich bei inneren Leitstrukturlagen Via-Lagen und Leitbahnlagen abwechseln müssen, um eine Verdrahtung mit guten elektrischen Eigenschaften zu gewährleisten, insbesondere mit einem kleinen RC-Produkt.

Bei einer nächsten Weiterbildung sind zwischen der substratnächsten Leitstrukturlage der drei Leitstrukturlagen und dem Substrat noch weitere Leitstrukturlagen angeordnet, bei denen sich beispielsweise Via-Lagen und Leitbahnen abwechseln.

Jedoch lassen sich auch die unteren Leitstrukturlagen als Lagen ausführen, die auch jeweils sowohl Vias als auch Leitbahnen enthalten.

Die Erfindung betrifft außerdem ein Verfahren mit den Merkmalen gemäß Anspruch 18 zur Herstellung der erfindungsgemäßen Schaltungsanordnung oder einer ihrer Weiterbildungen. Bei dem Verfahren werden die drei Leitstrukturlagen jeweils mit einem einfachen Damascene-Verfahren hergestellt. Bei einem einfachen Damascene-Verfahren wird nach dem Abscheiden einer oder mehrerer elektrisch isolierender Schichten zur Aufnahme der Leitstrukturen der jeweiligen Leitstrukturlage im Gegensatz zu einem dualen Damascene-Verfahren mit zwei fotolithografischen Verfahren nur ein einziges fotolithografisches Verfahren zur Strukturierung der Isolierschicht oder der Isolierschichten verwendet. Im Gegensatz zu einem dualen Damascene-Verfahren lässt sich das einfache Damascene-Verfahren mit einer höheren Ausbeute durchführen.

Die Erfindung betrifft außerdem eine integrierte Schaltungsanordnung mit integrierter Spule, eine integrierte Schaltungsanordnung mit integrierter Koaxialleitung und eine integrierte Schaltungsanordnung mit Kondensator. Diese passiven Bauelemente können auch in herkömmlichen Metallisierungslagen enthalten sein, in denen sich Vialagen und Leitbahnlagen abwechseln. Alternativ wird ein solches passives Bauelement jedoch gemeinsam mit einer oben erläuterten Schaltungsanordnung auf einem Substrat integriert, insbesondere auf einem einkristallinen Substrat, bspw. in mehreren aufeinanderfolgenden Leitbahnlagen oder unterhalb bzw. oberhalb von mehreren aufeinanderfolgenden Leitbahnlagen.

Die Erfindung bzw. ihre Weiterbildungen schlägt also eine prozess-technologisch leicht umsetzbare Designänderung mit großer Wirkung auf die Aspekte "Reduzierung der Leitbahnwiderstände", "Erfüllung der steigenden Stromtragfähigkeitsanforderungen", "Unterstützung der Wärmeabfuhr", "Realisierung von Spulen mit höchster Güte" sowie "Realisierung von vertikalen Kondensatoren" vor.

Die erfindungsgemäße Lösung bzw. ihre Weiterbildungen sieht eine Verdrahtung vor, bei der die ausschließlich dem vertikalen Stromtransport dienenden diskreten Vias der Standard Metallisierung teilweise oder ganz entfallen und durch Leitbahnebenen in Single Damascene Architektur ersetzt werden. Damit kann jede Metall-Lage Strom innerhalb dieser Ebene vertikal und lateral führen.

Die Erfindung bzw. ihre Weiterbildungen ist einsetzbar in allen Halbleitertechnologien mit Damascene-Verdrahtungs-Architektur (z.B. Kupfermetallisierung, Aluminiummetallisierung, Wolframmetallisierung). Sie kann prinzipiell jedoch auch mit subtraktiven Architekturen (z.B. Al-RIE (Reactive Ion Etching) realisiert werden.

### Technische Wirkungen:

Die Erfindung bzw. ihren Weiterbildungen ermöglichen in verschiedenen Ebenen die Realisierung von Leitbahnen mit deutlich größerem Querschnitt und damit und wegen des Entfalls der diskreten Vias niedrigerem Widerstand. Daraus leiten sich verschiedene weitere technische Wirkungen ab:
- Generell können im Vergleich zur Standard Metallisierung höhere Ströme und/oder längere Lebensdauern und/oder höhere Betriebstemperaturen, z.B. wichtig für sogenannte Automotive Anwendungen, ermöglicht werden.
- "Joule Heating", d.h. das Aufheizen von Leitbahnen durch hohe Betriebsströme und schlechte Wärmeabfuhr, wird deutlich verringert, da bei gleichem Strom die Stromdichte aufgrund des erhöhten Bahnquerschnitts und damit die Erwärmung geringer ausfallen. Bereits in der 90 nm Technologie, vor allem in isolierten Power-Bus-Leitbahnen, limitiert das "Joule-Heating-Kriterium" die nutzbare Stromdichte stärker als das reine DC-Kriterium (Direct Current).
- Generell sind höhere Stromdichten möglich. In der Metallisierung gemäß dem Stand der Technik ist die maximal nutzbare Stromdichte oft durch die Stromtragfähigkeit der Vias bzw. der Via/Bahn-Kontaktflächen begrenzt. In der erfindungsgemäßen Lösung können die Kontaktflächen zwischen Ebenen beliebig gewählt werden.
- Die Wirkung des "Size"-Effektes, gemäß dem der spezifische Widerstand von Kupferleitbahnen bei Abmessungen kleiner als 100 Nanometer stark zunimmt, d.h. der speziell in den unteren Ebenen mit minimaler Breite zum Tragen kommt, kann durch die Erfindung bzw. ihre Weiterbildungen deutlich reduziert werden. Damit steigt das RC-Glied speziell in diesen Ebenen weniger stark an als in der Standard Architektur und die Einführung von mechanisch labilen "ultra-low k" Dielektrika oder gar Airgaps kann hinausgeschoben oder ganz vermieden werden.

Die Erfindung bzw. ihre Weiterbildungen ermöglichen die Realisierung neuer integrierter Bauelemente oder von passiven Bauelementen mit bisher nicht erreichten physikalischen Güten:
- Mit sehr dicken Metallschichten durch Dopplung oder Tripplung einer bisherigen Bahnebene können Spulen höchster Güte erzeugt werden, insbesondere mit geringem Serienwiderstand,
- Bereitstellung von großflächigen Kapazitäten mit hohen Güten durch geringe Serien- und Anschlusswiderstände auf inter- und intralevel Basis,
- Die Realisierung perfekt abgeschirmter Koaxial-Leitungen oder HF-Transmissions-Bahnen (Hochfrequenz), z.B. größer als 1 Megahertz oder größer als 1 Gigahertz , wird erstmals zuverlässig möglich.

Die Erfindung bzw. ihren Weiterbildungen erlauben eine sicherere und kostengünstigere Prozessführung im Vergleich zum Stand der Technik:
- Die Erfindung bzw. ihre Weiterbildungen führt im Extremfall zu einem Aufbau, der ausschließlich in Single Damascene Architektur realisiert werden kann. Damit besteht sie aus einem einzigen, sich mehrfach wiederholenden Modul, das nur wenige Fertigungsanlagen benötigt.
- Die kritischen und ausbeutelimitierenden Prozesse, z.B. Viaätzung, -reinigung, -füllung in hohem Aspektverhältnis; hohe Kontroll- und Nacharbeitsrate, entfallen an den Stellen bzw. in den Ebenen, wo von der Erfindung bzw. ihren Weiterbildungen Gebrauch gemacht wird ganz oder teilweise. Höhere Ausbeuten bedeuten geringere Kosten pro Chip.
- Die Gesamtanzahl der Verdrahtungsebenen kann reduziert werden, was ebenfalls zu geringeren Kosten führt.
- Höhere Packungsdichte innerhalb der Metallisierung sind erzielbar, da größere Kontaktflächen ermöglicht werden als bisher. Deswegen ist kein die Packungsdichte negativ beeinflussender Vorhalt (Überlapp) notwendig, um eine minimale Kontaktfläche sicherzustellen,
- Die Forderung nach "redundanten" Vias, die im Stand der Technik zur Absicherung höherer Stromdichten oder zur Ausbeuteerhöhung häufig erhoben wird, kann wesentlich leichter und einfacher, d.h. insbesondere auch ohne zusätzlichen Flächenzuwachs, realisiert werden, wenn möglichst wenige diskrete Vias mit minimalen Abmessungen in x- und y-Richtung verwendet werden.
- Die Erfindung bzw. ihre Weiterbildungen erlauben die Querschnittsvergrößerung von Bahnen durch Vergrößerung der vertikalen Dimension und damit ist eine Flächeneinsparung verbunden, da laterale Abmessungen verkleinert werden können.
- Die Erfindung bzw. ihre Weiterbildungen ermöglichen größere Freiheiten und Optionen im Design.
- Sie können wahlweise mit der Architektur gemäß dem Stand der Technik kombiniert werden (z.B. untere, minimal breite Bahnen gemäß herkömmlicher Architektur; höhere, globale Leitbahnen gemäß der neuen Architektur.
- Die laterale Dimension der Bahnen in der "ehemaligen" diskreten Via-Ebene kann im Rahmen der (Damascene-)Designregeln beliebig und stufenlos gewählt werden.
- Mit der Erfindung bzw. ihre Weiterbildungen können unterschiedliche Anforderungen von kombinierten oder embedded-Technologien erfüllt werden, z.B. "dicke" und "dünne" Verdrahtung in BiCMOS-Technologien (Bipolar Complementary Metal Oxide Semiconductor).
- Mit der Erfindung bzw. ihren Weiterbildungen kann die Stromverteilung über den Chip besser und gleichmäßiger gestaltet werden.
- Aufgrund des im Vergleich zum Stand der Technik geringeren Bahnwiderstandes ist der Leistungsverlust geringer und die Zahl der benötigten "Repeater" im Design verringert sich.
- Die Erfindung bzw. ihre Weiterbildungen beeinflusst das RC-Glied (Widerstand, Kapazität) in den zunehmend die Gesamtperformance limitierenden Interconnects nicht negativ. Wichtig ist, dass die Erfindung bzw. ihre Weiterbildungen eine bisher nicht verfügbare technologische Lösung bietet, den Widerstand von Bahnen zu reduzieren ohne gleichzeitig den Flächenbedarf für die Verdrahtung und die vertikale Kopplung zwischen Leitbahnen zu erhöhen.
- Eine genauere Betrachtung zeigt sogar positive Auswirkungen der Erfindung bzw. ihre Weiterbildungen auf das RC-Glied, bspw. wächst der Faktor C nicht direkt proportional zur Leitbahndicke sondern weniger stark an und somit wird das resultierende Produkt RC sogar kleiner. Auch die Reduzierung des "Size"-Effektes führt zu einem kleinen RC-Produkt.
- Bei lokaler Verdrahtung ist zudem häufig nicht die Leitungskapazität, sondern die zu treibende Kapazität, z.B. die Gatekapazität von MOS-Transistoren, dominierend, so dass als positive Auswirkung die Abnahme des Widerstands und damit des RC-Produktes proportional 1/d verbleibt, wobei d die Gesamtleitbahndicke über eine bzw. bei Leitbahndoppelung bzw. - trippelung über mehrere Metallisierungslagen ist.

Das kann nicht nur bei handoptimiertem "full custom"-Layout, sondern unter Verwendung der heute üblichen Verdrahtungskonzepte auch in synthetisierten "semi custom"-Blöcken genutzt werden. So kann man z.B. 11 Metalllagen je nach Anforderungen auf demselben Chip entweder durch 6 einfache Bahnebenen und 5 Viaebenen (in weniger performancekritischen Blöcken) oder durch 4 doppelte Bahnebenen und 3 Viaebenen (in performancekritischen Blöcken) realisieren.

Damit wird eine Verdrahtung angegeben, bei der in allen oder in ausgewählten Ebenen die überwiegend dem vertikalen Stromtransport dienenden diskreten Vias der Standard Metallisierung teilweise oder ganz entfallen und durch Leitbahnebenen ersetzt werden. Damit können die betreffenden Metall-Lagen Strom innerhalb dieser Lage bzw. Ebene vertikal und lateral führen.

Zusammenfassend gilt, dass die Erfindung bzw. ihre Weiterbildungen die Minderung oder Lösung folgender technischer Probleme betrifft:
- Verhinderung einer immer komplizierter werdenden Verdrahtung bzw. der sogenannten "Verdrahtungskatastrophe" in zukünftigen hochintegrierten Halbleitersystemen,
- Verringerung des Verdrahtungswiderstandes, insbesondere bei Spannungsversorgungsleitungen (Power Routing) und Induktivitäten,
- Verringerung des RC-Gliedes, z.B. bei Bussystemen,
- Verringerung von Kopplungen und Übersprechen durch Abschirmen kritischer Leitungen, insbesondere durch 3D (drei Dimensional) Verdrahtung, z.B. koaxial, und HF-Leitbahnen,
- Reduzierung der Verlustleistung und Erwärmung der Bauelemente bzw. integrierten Schaltungsanordnungen, insbesondere bei Verwendung von "low-k Dielektrika" mit relativen Dielektrizitätskonstanten kleiner als 3,9 bzw. kleiner als 3,
- Reduzierung des sogenannten "size-Effektes" in zukünftigen Verdrahtungen, wonach der ohmsche Widerstand von KupferLeitbahnen bereits ab der 90 nm (Nanometer) Technologie stärker als rein durch die Skalierung erwartet ansteigt.
- Reduzierung der Zuverlässigkeitseinbußen, insbesondere hervorgerufen durch stromdichte-/widerstandskritischen Leitbahn-/Via-Übergänge,
- Ausbeuteeinbußen und komplizierte Prozessführung mit schmalen "Prozessfenstern", insbesondere durch Reduzierung der benötigten Anzahl an ausbeutelimitierenden Vias und Verwendung der weniger anspruchsvollen "Single Damascene Architektur"

Im Folgenden werden Ausführungsbeispiele der Erfindung an Hand der beiliegenden Zeichnungen erläutert. Darin zeigen:
- Figur 1: einen Querschnitt durch die Metallisierung einer integrierten Schaltungsanordnung,
- Figur 2: eine räumliche Ansicht der Metallisierung einer integrierten Schaltungsanordnung,
- Figur 3: eine in einer Metallisierung angeordnete Spule bzw. Induktivität,
- Figur 4: eine in einer Metallisierung angeordnete integrierte Koaxialleitung,
- Figur 5: eine in einer Metallisierung angeordnete Spule, und
- Figur 6: einen Querschnitt durch eine Metallisierung mit integriertem Kondensator.

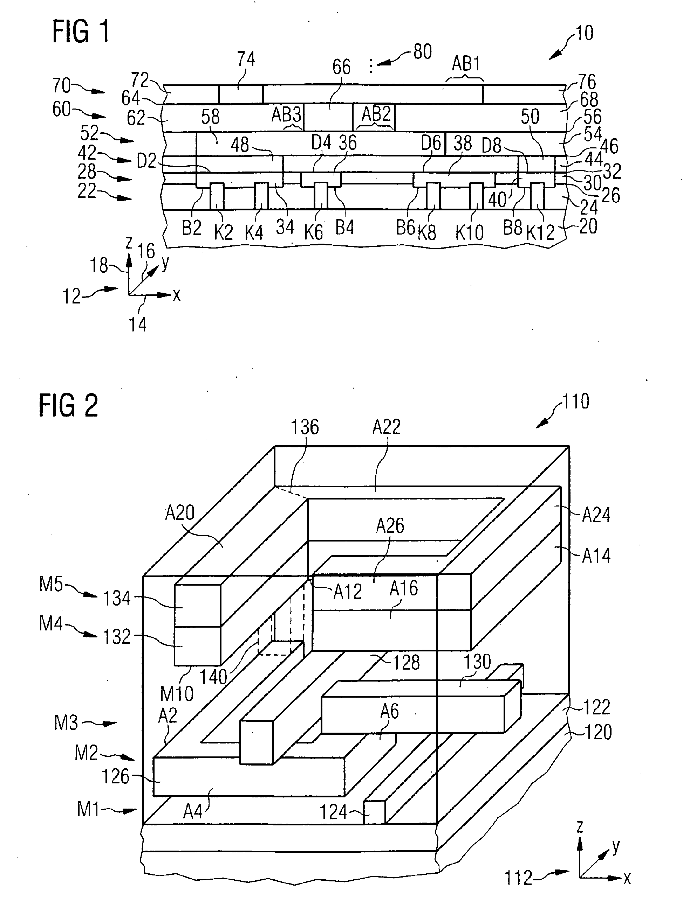

Figur 1 zeigt einen Querschnitt durch die Metallisierung einer integrierten Schaltungsanordnung 10. Der Querschnitt liegt in einer Ebene, in der auch die Normalenrichtung der Hauptfläche eines Substrats 20 liegt, das eine Vielzahl integrierter Bauelemente enthält, beispielsweise integrierter Bipolartransistoren oder Feldeffekttransistoren.

Ein kartesisches Koordinatensystem 12 hat eine x-Achse 14, eine y-Achse 16 und eine z-Achse 18. Der in Figur 1 gezeigte Querschnitt liegt in der x-z-Ebene. Die Hauptfläche des Substrats 20 liegt dagegen in der x-y-Ebene. Im Zusammenhang mit den Figuren 2 bis 6 sind jeweils Koordinatensysteme 112, 212, 312, 412 bzw. 512 gezeigt, für deren Lage das zum Koordinatensystem 12 Gesagte gilt.

Unmittelbar über dem Substrat 20 enthält die Schaltungsanordnung 10 eine Kontaktlage 22, die unter anderem Kontakte K2, K4, K6, K8, K10 und K12 enthält. Die Kontakte K2 bis K12 dienen dem vertikalen Stromtransport. Beispielsweise werden die Kontakte K2 bis K12 aus Wolfram einschließlich einer elektrisch leitfähigen Auskleidungsschicht aus einem anderen Material als Wolfram gebildet. Die Kontakte K2 bis K12 haben alle die gleichen lateralen Abmessungen.

Beim Herstellen der Kontaktlage 22 wird eine elektrisch isolierende Isolierschicht 24 aufgebracht, beispielsweise aus Siliziumdioxid. In die Isolierschicht 24 werden mit Hilfe eines fotolithografischen Verfahrens Kontaktlöcher für die Kontakte K2 bis K12 geätzt. Anschließend wird das Material zur Auskleidung der Kontaktlöcher abgeschieden. Danach folgt die Abscheidung der Metallisierung für die Kontakte K2 bis K12. Anschließend wird beispielsweise ein CMP-Schritt durchgeführt, bei dem dasjenige Material der Auskleidungsschicht und Kontaktmaterial abgetragen wird, das außerhalb der Kontaktlöcher für die Kontakte K2 bis K12 liegt. Nach dem Planarisieren wird eine elektrisch isolierende Hilfsschicht 26 abgeschieden, die im Vergleich zur Dicke der Isolierschicht 24 dünn ist. Beispielsweise liegt die Dicke der Isolierschicht 24 im Bereich von 100 nm bis 500 nm. Die Dicke der Hilfsschicht 26 liegt beispielsweise im Bereich von 30 nm bis 70 nm. Die Hilfsschicht 26 dient als Ätzstoppschicht und/oder als Barriereschicht gegen Kupferdiffusion. Ein geeignetes Material für die Hilfsschicht 26 ist beispielsweise Siliziumnitrid.

Nach dem Abscheiden der Hilfsschicht 26 wird eine Isolierschicht 30 aus einem elektrisch isolierenden Material mit einer Schichtdicke abgeschieden, die beispielsweise im Bereich von 200 nm bis 500 nm liegt. Mit Hilfe eines fotolithografischen Verfahrens werden Gräben und Aussparungen bzw. Löcher für Leitstrukturen einer Metallisierungslage 28 erzeugt, die im Folgenden auch als Metallisierungslage 1 bezeichnet wird. Die Leitstrukturen in der Metallisierungslage 28 haben voneinander verschiedene Abmessungen in x-Richtung.

Außerdem haben die Leitstrukturen auch voneinander verschiedene Abmessungen in y-Richtung. Beim Ätzen der Gräben bzw. Aussparungen für die Leitstrukturen der Metallisierungslage 28 wird die Hilfsschicht 26 durchbrochen, weil etwas überätzt wird. Danach werden in der üblichen Damascene-Technik unter anderem lokale Leitbahnen 34, 36 und 38 sowie ein Via 40 erzeugt. Die Leitbahn 34 erstreckt sich in x-Richtung und verbindet die Kontakte K2 und K4. Die Leitbahn 36 erstreckt sich dagegen in y-Richtung und dient zum Anschluss des Kontaktes K6 an eine nicht dargestellte Leitstruktur oder an einen nicht dargestellten Kontakt der Kontaktlage 22. Die Leitbahn 38 erstreckt sich in x-Richtung und verbindet die Kontakte K8 und K10. Die Leitbahnen 34, 36 und 38 haben beispielsweise eine minimale laterale Breite im Bereich von 80 nm bis 200 nm. Die Länge der Leitbahnen 34, 36 und 38 ist jeweils größer als beispielsweise 500 nm (Nanometer), jedoch kleiner als 1 µm (Mikrometer) und insbesondere kleiner als 10 µm.

Das Via 40 hat dagegen in x-Richtung und in y-Richtung die gleiche laterale Abmessung und dient zum Anschluss des Kontaktes 12 an eine Leitbahn einer über der Metallisierungslage 28 angeordneten Metallisierungslage 42. Vor dem Erzeugen der Metallisierungslage 42 wird wiederum mit Hilfe eines CMP-Schrittes planarisiert.

In Figur 1 sind außerdem Bodenfläche B2, B4, B6 und B8 sowie Deckflächen D2, D4, D6 bzw. D8 der Leitbahnen 34, 36, 38 bzw. des Vias 40 gezeigt. Die Deckflächen D2 bis D8 liegen im Ausführungsbeispiel in einer Ebene. Die Bodenflächen B2 bis B8 liegen dagegen aufgrund des besseren Ineinandergreifens der Kontaktlage 22 in die Metallisierungslage 28 in zwei Ebenen, wobei der Abstand zwischen den beiden Ebenen jedoch kleiner als 50 nm und insbesondere kleiner als 20 nm ist. Innerhalb dieses Abstands greifen die Metallisierungslagen 22 und 28 ineinander.

Nach dem CMP-Schritt wird eine Hilfsschicht 32 abgeschieden, für deren Materialzusammensetzung und Dicke das zur Hilfsschicht 26 Gesagte gilt. Nach dem Abscheiden der Hilfsschicht 32 wird eine weitere elektrisch isolierende Isolierschicht 44 abgeschieden, die im Ausführungsbeispiel dicker als die Isolierschicht 30 ist, beispielsweise um mindestens 50 nm. In der Isolierschicht 44 werden mit Hilfe eines einfachen Damascene-Verfahrens unter anderem Leitbahnen 48 und 50 der Metallisierungslage 42 erzeugt. Die Metallisierungslage 42 enthält außerdem auch nicht dargestellte Vias. Die Leitstrukturen 48, 50 sind wie im Übrigen auch die Leitstrukturen 34 bis 40 mit einer Auskleidungsschicht ausgekleidet, die eine Kupferdiffusionsbarriere ist, beispielsweise mit einer Tantalnitridschicht. Die Leitbahn 48 erstreckt sich in x-Richtung und hat bis auf Bearbeitungstoleranzen die gleiche Länge wie die Leitbahn 34. Somit dient die Leitbahn 48 zum vertikalen Stromtransport zwischen der Leitbahn 34 und einer über der Leitbahn 48 angeordneten Leitstruktur der nächsthöheren Metallisierungslage 52, sowie zum lateralen Stromtransport zwischen den Kontakten K3 und K4. Die Leitbahn 50 erstreckt sich in y-Richtung und dient zum Anschluss des Vias 40.

Nach einem CMP-Schritt wird wiederum eine Hilfsschicht 46 abgeschieden, für deren Materialzusammensetzung und Dicke das zur Hilfsschicht 26 Gesagte gilt. Anschließend wird eine elektrisch isolierende Isolierschicht 54 abgeschieden, die beispielsweise die gleiche Dicke wie die Isolierschicht 44 oder eine um 50 nm größere Dicke als die Isolierschicht 44 hat. In der Isolierschicht 54 werden mit Hilfe eines einfachen Damascene-Verfahrens Aussparungen für Leitbahnen und Vias erzeugt, siehe beispielsweise die Aussparung für eine Leitbahn 58. Nach einer elektrolytischen Kupferabscheidung folgt wiederum ein CMP-Schritt.

Anschließend wird eine elektrisch isolierende Hilfsschicht 56 aufgebracht, für deren Materialbeschaffenheit und Dicke das zur Hilfsschicht 26 Gesagte gilt.

Danach wird eine elektrisch isolierende Isolierschicht 62 einer Metallisierungslage 60 aufgebracht, in der sowohl Vias als auch Leitbahnen, z.B. 66, 68, hergestellt werden. Die Leitstrukturen der Metallisierungslage 60 werden ebenfalls mit Hilfe eines einfachen Damascene-Verfahrens hergestellt.

Nach einem nächsten CMP-Schritt wird eine Hilfsschicht 64 aufgebracht, für die das zur Hilfsschicht 26 Gesagte gilt. Danach wird eine Isolierschicht 72 aufgebracht, in der Leitstrukturen 74 und 76 einer Metallisierungslage 70 erzeugt werden. Weitere Metallisierungslagen 80 sind durch Punkte angedeutet.

Die Leitbahn 58 verläuft in x-Richtung und grenzt mit ihrem linken Ende an die Leitbahn 48 an. Ein mittlerer Teil der Leitbahn 58 grenzt an die Leitbahn 66 an. Das rechte Ende der Leitbahn 58 grenzt an die in x-Richtung verlaufende Leitbahn 68 an.

Die Leitbahn 74 verläuft in y-Richtung. Die Leitbahn 76 verläuft in x-Richtung und grenzt mit ihrem linken Ende an einen rechten Teil der Leitbahn 68 an. Abschnitte AB1 bis AB3 der Leitbahn 68 bzw. der Leitbahn 58 grenzen an keine weiteren Leitstrukturen an. Die Abschnitte AB1, AB2 und bzw. AB3 haben jeweils eine Länge, die mindestens das Fünffache der Breite der Leitbahn 58 bzw. 68 beträgt.

Somit liegen die Kontaktlage 22, sowie die Metallisierungslagen 28, 42, 52, 60, 70, 80 parallel zur Hauptfläche des Substrats 20 in x-y-Ebenen.

Figur 2 zeigt eine räumliche Ansicht der Metallisierung einer integrierten Schaltungsanordnung 110, die wie die Schaltungsanordnung 10 mehrere aufeinanderfolgende Leitbahnlagen M1 bis M5 enthält. Die Leitstrukturen der Schaltungsanordnung 110 sind ebenfalls in einfach Damascene-Technik hergestellt, so dass auf die diesbezüglichen Erläuterungen zur Figur 1 verwiesen wird.

Die Schaltungsanordnung 110 enthält ebenfalls ein Halbleitersubstrat 120, beispielsweise aus einkristallinem Silizium. Zwischen dem Halbleitersubstrat 120 und einer ersten in Figur 2 dargestellten Metallisierungslage befindet sich eine Kontaktlage 122, die beispielsweise wie die Kontaktlage 22 aufgebaut ist. In der darüber liegenden Metallisierungslage M1 ist eine in y-Richtung verlaufende Leitbahn 124 dargestellt. In einer über der Metallisierungslage M1 angeordneten Metallisierungslage M2 ist unter anderem eine Leitbahn 126 angeordnet, die drei aufeinanderfolgende Abschnitte A2, A4 und A6 hat, wobei die beiden Abschnitte A2 und A6 in y-Richtung liegen. Der Abschnitte A4 verbindet die Abschnitte A2 und A6 an ihren Enden und verläuft in x-Richtung. Der Abschnitt A6 ist beispielsweise länger als der Abschnitt A2.

In einer über der Metallisierungslage M2 angeordneten Metallisierungslage M3 sind zwei Leitbahnen 128 und 130 dargestellt. Die Leitbahn 128 erstreckt sich in y-Richtung von einem mittleren Teil des Abschnitts A4, an den sie auch angrenzt. Die Leitbahn 130 erstreckt sich dagegen in x-Richtung vom freien Ende des Abschnitts A6 ausgehend, an den sie auch angrenzt. Beispielsweise enthält die Metallisierungslage M3 auch ein Via 140 am freien Ende des Abschnitts A2 an Stelle der Leitbahn 128.

Die Metallisierungslage M4 enthält eine Leitbahn 132, die Abschnitte A10, A12, A14 und A16 enthält, die in dieser Reihenfolge in y-Richtung, in x-Richtung, in y-Richtung und in x-Richtung liegen und die etwa 3/4 eines Rechteck- oder Quadratrahmens bilden. Der Abschnitt A16 grenzt an die Leitbahn 128 an. Alternativ grenzt das Via 140 an den Abschnitt A10 an.

In der über der Metallisierungslage M4 angeordneten Metallisierungslage M5 ist eine Leitbahn 134 dargestellt, die in dieser Reihenfolge Abschnitte A20, A22, A24 und A26 enthält. Die Abschnitte A20 bis A26 haben in der Metallisierungslage M4 die gleiche Lage wie die Abschnitte A10 bis A16 in der Metallisierungslage M3, wobei eine gleiche x,y-Position in beiden Lagen als Bezugspunkt dient. Somit liegt beispielsweise der Abschnitt A20 unmittelbar oberhalb des Abschnitts A10 und grenzt entlang seiner gesamten Länge an diesen Abschnitt A10 an. Damit bilden die Leitbahnen 132 und 134 eine sogenannte "gedoppelte" Leitbahn, deren Leitungsquerschnitt im Vergleich zu dem Querschnitt einer Leitbahn 132 bzw. 134 vergrößert ist, z.B. verdoppelt. Bei anderen Ausführungsbeispielen werden auch dreifach oder mehr als dreifach übereinander angeordnete Leitbahnen verwendet, beispielsweise für Leitungen, über die große Ströme fließen, insbesondere für Versorgungsspannungsleitungen.

Als Grenze zwischen den Abschnitten einer Leitbahn lässt sich beispielsweise die Verbindungsfläche zwischen innerer und äußerer Kante an einer Stelle festlegen, an der die Leitbahn ihren Verlauf ändert, siehe beispielsweise Hilfslinie 136. Längenangaben lassen sich dann beispielsweise auf eine mittlere Länge an dieser Hilfslinie 136 beziehen.

Alle Metallisierungslagen M1 bis M5 enthalten bspw. außerdem nicht dargestellte Via-Leitstrukturen, die nur dem vertikalen Stromtransport dienen und die beispielsweise in x-Richtung und y-Richtung die gleiche Abmessung haben. Alternativ sind keine Vias in den Metallisierungslagen M1 bis M5 vorhanden.

Die Figuren 1 und 2 zeigen die Lösung schematisch. Die Auswahl der Ebenen, in denen die Erfindung umgesetzt wird, kann je nach Technologie, Notwendigkeit, Anforderungen und zu integrierenden Bauelementen individuell getroffen werden. Bevorzugt erfolgt die Anwendung in einer oder mehrerer Lagen der "global interconnects", z. B. bei power rails oder power grids (digitale Schaltungsblöcke), power Bus-Leitungen, ESD-Bussen (Electro Static Dicharge) (analog/mixed Signal Schaltungsblöcke), 3D Verdrahtung (koaxial), Induktivitäten, HF-Leitbahnen (Hochfrequenz) etc. Sie ist aber auch bei "local interconnects" einsetzbar, z.B. Anschlüsse von ESD-Schutzelementen (Elektro Static Discharge), und dort unter bestimmten Aspekten hilfreich.

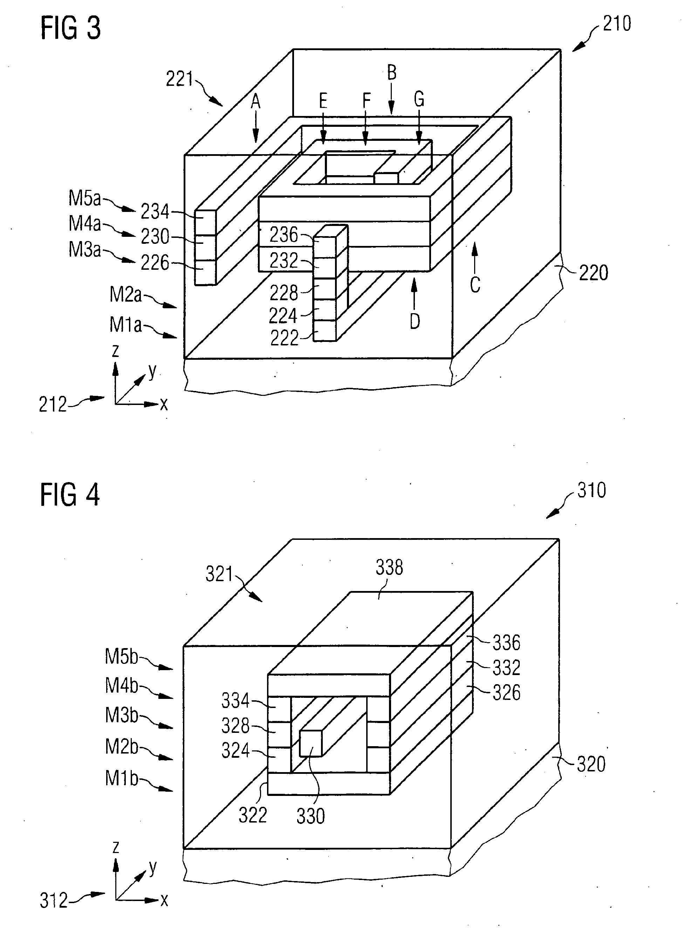

Figur 3 zeigt eine in einer Metallisierung einer integrierten Schaltungsanordnung 210 angeordnete Spule 221 bzw. Induktivität. Es werden zur Herstellung der Schaltungsanordnung 210 zunächst Prozessschritte zur Herstellung mikroelektronischer Devices auf einem Substrat 220, wie z. B. Si-Wafern, durchgeführt. Danach werden nicht dargestellte Kontakte einer Kontaktlage erzeugt. Anschließend werden eine Metallisierungslage M1a und eine Metallisierungslage M2a erzeugt, z.B. mit zwei nacheinander ausgeführten einfach Damascene-Verfahren. In Figur 3 ist eine Leitbahn 222 der Metallisierungslage M1a dargestellt, die in y-Richtung ausgerichtet ist und die eine Zuleitung zu der Spule 221 bildet.

Die Metallisierungslage M2a enthält unter anderem ein Via 224, das an das eine Ende der Leitbahn 222 grenzt. Eine in Figur 3 nicht dargestellte Leitbahn der Metallisierungslage M2a liegt zwischen dem anderen Ende der Leitbahn 222 und der Wicklung der Spule 221.

Die Erzeugung einer nächsten Metallisierungslage M3a erfolgt bspw. in Single-Damascene (SD)-Architektur durch Abscheidung einer IMD-Schicht (Inter Metall Dielektrikum), z.B. aus SiO₂ oder low-k Material, und optionaler etch-stop-, ARC- (Anti Reflection Coating) und hard mask-Schichten mittels der an Hand der Figur 1 erläuterten Verfahren. Es folgt die Erzeugung von Gräben für eine Leitbahn 226 mittels gängiger Belackungs-, Lithographie-, Ätz-Strip- und Reinigungsschritten. Die Gräben haben bspw. eine Tiefe im Bereich von 0,5 Mikrometern bis zu 2 Mikrometer. Die Breite der Gräben liegt bspw. in dem gleichen Bereich. Die bekannte Abscheidung von Barriere und Leitbahnmaterial sowie nachfolgende CMP- und Reinigungsschritte sowie Abscheidung einer dielektrischen Deckschicht (cap) beenden die Erzeugung der Metallisierungslage M3a in SD Architektur mit entspannter Geometrie. Das innere Ende der Leitbahn 226 grenzt an die in Figur 3 durch die Spulenwindungen verdeckte Leitbahn der Spule 221 in der Metallisierungslage M2a an. Außerdem wird in der Metallisierungslage M3a ein Via 228 an der gleichen Position wie das Via 224 in der Metallisierungslage M2a erzeugt.

Eine Metallisierungslage M4a ersetzt an dieser Stelle eine Ebene bzw. Lage mit diskreten Vias. Die lateralen Abmessungen der vierten Metallisierungslage M4a sind an der Stelle der zu erzeugenden Spule jenen der Metallisierungslage M3a angepasst, an anderen Stellen sind sie beliebig (im Rahmen der Designregeln) wählbar. Die Grabentiefe liegt wiederum innerhalb des oben angegebenen Bereichs. Der Ablauf der Herstellungsschritte für die Metallisierungslage M4a in SD Architektur entspricht im Wesentlichen der Beschreibung für die Metallisierungslage M3a. In der Metallisierungslage M4a wird eine Leitbahn 230 erzeugt, die den gleichen Verlauf wie die Leitbahn 226 hat und die in ihrem gesamten Verlauf an die Leitbahn 2226 grenzt. Weiterhin enthält die Metallisierungslage M4a ein Via 232 oberhalb des Vias 228.

Unter Nutzung des modularen Aufbaus wird eine Metallisierungslage M5a mit den gleichen Prozessschritten ebenfalls in SD Architektur erzeugt. Die Dimensionen sind analog zu den Schritten vorher. Dabei wird eine Leitbahn 234 erzeugt, die im Bereich der Spule 221 den gleichen Verlauf wie die Leitbahn 230 hat und die außerdem den anderen Anschluss der Spule 221 bildet. Die Metallisierungslage M5a enthält außerdem ein Via 236, das oberhalb des Vias 232 angeordnet ist.

Wie in Figur 3 zu sehen ist, wurde so eine integrierte Spule 221 erzeugt, die bspw. eine Wicklungshöhe im Bereich von 1,5 Mikrometer bis 6 Mikrometer hat, wie sie in klassischer Dual-Damascene-Architektur nur schwierig und unter hohem Kostenaufwand realisiert werden kann. Der Wicklungsquerschnitt, d.h. die Breite mal die Höhe, ist deutlich größer als bei einem vergleichbaren Bauelement in Standard-Architektur. Konkret beträgt die Höhe der Wicklung das Dreifache, mindestens aber das Anderthalbfache einer vergleichbaren Spule in Standard-Architektur. Damit ermöglicht sie bei sonst gleichen Dimensionen deutlich höhere physikalische Güte-Werte als die Referenzspule. Alternativ könnte mit der erfindungsgemäßen Architektur eine Spule mit zum Standard vergleichbarer Güte durch geringere laterale Abmessungen erhalten werden, was deutliche Flächenersparnisse bringen würde. Die Zu- und Ableitung der Anschlüsse erfolgt bspw. in der obersten, d.h. hier in der Metallisierungslage M5a, bzw. in der unteren (hier ersten) Lage mit Hilfe eines "underpasses".

Die Spule 221 hat 1 ¾ Windungen, welche durch aufeinanderfolgende Abschnitte A, B, C, D, E, F und G der Dreifachleitbahn 226, 230 und 234 gebildet werden. Die Abschnitte A, C, E und G erstrecken sich in y-Richtung und haben in der genannten Reihenfolge abnehmende Längen. Die Abschnitte B, D und F erstrecken sich dagegen in x-Richtung und haben in dieser Reihenfolge ebenfalls abnehmende Längen. Die Breite der Leitbahnen 226, 230 und 243 liegt bspw. im Bereich von 1 Mikrometer bis zu 10 Mikrometer. Die Länge der Leitbahn 226, 230 bzw. 243 liegt jeweils bspw. im Bereich von 10 Mikrometer bis zu 500 Mikrometer.

Die weitere Prozessierung und Fertigstellung der Schaltung erfolgt mit den üblichen Methoden und Verfahren.

Bei anderen Ausführungsbeispielen liegt die Spule 221 in anderen Metallisierungslagen bzw. die Wicklung liegt nur in zwei, vier oder mehr als vier Metallisierungslagen.

Figur 4 zeigt eine in einer Metallisierung einer integrierten Schaltungsanordnung 310 angeordnete Koaxialleitung 321. Zunächst werden Prozessschritte zur Herstellung mikroelektronischer Bauelemente auf einem Substrat 320, wie z. B. einem Silizium-Wafer, ausgeführt. Es folgt die Erzeugung von in Figur 4 nicht dargestellten Kontakten und einer metallischen Metallisierungslage M1b mit den bekannten Vorgehensweisen der Technik. An der Stelle der Koaxialleitung 321 ist eine die Bodenplatte der Koaxialleitung 321 bildende Leitbahn 322 mit rechteckigem Umriss besonders breit ausgeführt, z.B. mit einer Breite im Bereich von 10 Mikrometern bis 20 Mikrometern, insbesondere mit einer Breite von 14 µm.

Es folgt die Erzeugung einer Metallisierungslage M2b in Single Damascene (SD) Architektur durch Abscheidung einer IMD-Schicht (SiO2 oder low-k Material) und optionaler etch-stop-, ARC- und hard mask-Schichten mittels gängiger Verfahren. Es folgt weiterhin die Erzeugung der Gräben bspw. mit den oben genannten Abmessungen mittels gängiger Belackungs-, Lithographie-, Ätz-, Strip- und Reinigungsschritten. Die bekannte Abscheidung von Barriere und Leitbahnmaterial sowie nachfolgende CMP- und Reinigungsschritte sowie Abscheidung eines dielektrischen Caps beenden die Erzeugung der Metallisierungslage M2b in SD Architektur mit entspannter Geometrie. Die Breite der zweiten Metall-Lage ist an der Stelle der Koaxialleitung mit z.B. 2 µm deutlich geringer als die der unteren Lage. Zwei Leitbahnen 324, 326 in der Metallisierungslage M2b schließen bspw. bündig mit den Längsseiten der Leitbahn 322 ab.

Unter Ausnutzung des modularen Aufbaus wird eine Metallisierungslage M3b mit den gleichen Prozessschritten ebenfalls in SD Architektur erzeugt. Lage, Länge und Breite von Leitbahnen 328 bzw. 332 stimmen mit den in der Metallisierungslage M2b gewählten Werten für die Leitbahnen 324 bzw. 326 überein. Zusätzlich wird in der Maske für die Metallisierungslage M3b eine weitere, bspw. 2 µm breite Leitbahn 330 vorgesehen und im Zuge der Prozessierung erzeugt. Die Leitbahn 330 liegt mittig zwischen den beiden äußeren Leitbahnen 328 und 332 in dieser Metallisierungslage M3b. Die Leitbahn 330 erstreckt sich, wie die gesamte Koaxialleitung 321 in x-Richtung, bspw. um mehr als 50 Mikrometer oder um mehr als 100 Mikrometer.

Unter erneuter Ausnutzung des modularen Aufbaus wird eine Metallisierungslage M4b mit den gleichen Prozessschritten ebenfalls in SD Architektur erzeugt. Lage, Länge und Breite von Leitbahnen 324 bzw. 332 stimmen mit den in der Metallisierungslage M2b gewählten Werten für die Leitbahn 324 bzw. 326 überein. Die Leitbahnen 324, 328 und 334 bilden die eine Seitenwand der Koaxialleitung 321. Die Leitbahnen 326, 332 und 336 bilden dagegen die andere Seitenwand der Koaxialleitung 321.

Ebenfalls unter Ausnutzung des modularen Aufbaus wird eine Metallisierungslage M5b mit den gleichen Prozessschritten wiederum in SD Architektur erzeugt. Lage, Länge und Breite einer die Deckplatte der Koaxialleitung 321 bildenden Leitbahn 338 stimmen mit den in der Metallisierungslage M1b für die Leitbahn 322 gewählten Werten überein. Damit ist eine in Umfangsrichtung vollständig geschlossene abschirmende Ummantelung um die in der Metallisierungslage M3b angeordnete zentrale Koaxial-Leitbahn 330 entstanden.

In den beschriebenen Prozess-Schritten wurden Dimensionen nur für das gerade interessierende Bauelement genannt. Selbstverständlich können, im Rahmen der Designregeln, an anderer Stelle auf dem Wafer Strukturen mit anderen lateralen Dimensionen gefertigt werden, die zu anderen Schaltungsteilen gehören, insbesondere zu den an Hand der Figuren 1 bis 6 erläuterten Schaltungsanordnungen.

Die weitere Prozessierung und Fertigstellung der Schaltung erfolgt mit den üblichen Methoden und Verfahren. Bei anderen Ausführungsbeispielen werden mehr als fünf Metallisierungslagen zur Herstellung der Koaxialleitung verwendet. Bspw. wird dann die abgeschirmte mittlere Leitung durch Leitbahnen in zwei Metallisierungslagen gebildet. Auch eine Koaxialleitung mit mehreren voneinander isolierten Innenleitern wird gemäß einem anderen Ausführungsbeispiel gefertigt, wobei die Innenleiter in einer Metallisierungslage oder in mehreren Metallisierungslagen liegen und wobei die Ummantelung in einem Querschnitt senkrecht zur Längsachse der Koaxialleitung bspw. ein Quadrat oder ein Rechteck umschreibt. Bei anderen Ausführungsbeispielen ändert sich der Verlauf der Koaxialleitung, bspw. sowohl in x-Richtung als auch in y-Richtung. Auch die Abmessungen der Leitstrukturen in den einzelnen Metallisierungslagen M1b bis M5b sind wählbar, z.B. minimale laterale Breiten der Leitbahnen für die Seitenwände bzw. für die Innenleiter im Bereich von 0,1 Mikrometer bis 2 Mikrometer.

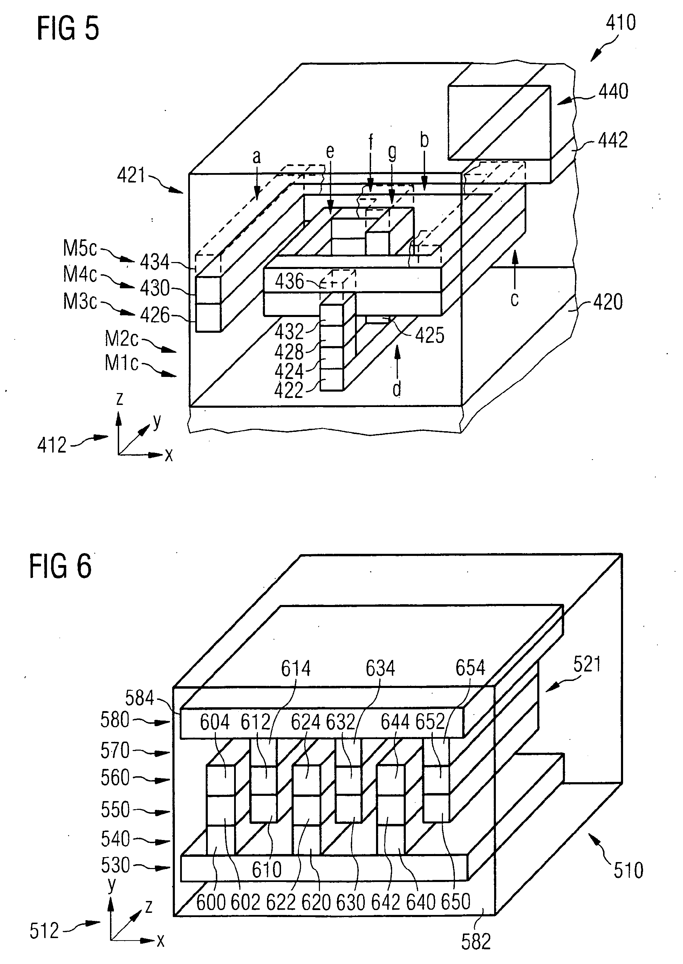

Figur 5 zeigt eine in einer Metallisierung einer integrierten Schaltungsanordnung 410 angeordnete Spule 421. Zunächst werden Prozessschritte zur Herstellung mikroelektronischer Devices auf einem Substrat 420, wie z.B. auf einem Siliziumwafer, durchgeführt. Dann folgt die Erzeugung von Kontakten einer nicht dargestellten Kontaktlage und von Leitstrukturen einer Metallisierungslage M1c und einer Metallisierungslage M2c mit den an Hand der Figur 3 erläuterten Techniken. Es entsteht ein in der Metallisierungslage M1c eine Leitbahn 422, die in ihren Abmessungen, in ihrer Lage und in ihrem Material der Leitbahn 222 entspricht. In der Metallisierungslage M2c entsteht unter anderem ein Via 424, das dem Via 224 entspricht.

Eine Leitbahn 425 entspricht der an Hand der Figur 2 erläuterten Leitbahn der Metallisierungslage M2a.

Die Erzeugung der Metallisierungslage M3c erfolgt wie die Herstellung der Metallisierungslage M3a, wobei u.a. eine der Leitbahn 226 entsprechende Leitbahn 426 der Spule 421 sowie ein dem Via 228 entsprechendes Via 428 erzeugt werden. Als Leitbahnmaterialien für die Leitbahn 426 kommen W oder Cu, aber auch Al, Au, Ag oder andere in Frage. Die Metallisierungslage M3c ersetzt an dieser Stelle eine Ebene mit diskreten Vias.

Eine Metallisierungslage M4c wird nun mittels RIE oder einer anderen subtraktiven Strukturierungstechnik erzeugt, wobei u.a. eine der Leitbahn 230 entsprechende Leitbahn 430 und ein dem Via 232 entsprechendes Via 432 erzeugt werden. Unmittelbar im Anschluss an den zuvor erfolgten CMP-Prozess erfolgt die Abscheidung einer Barrierenschicht bzw. eines Barriereschichtstapels wie TaN/Ti/TiN mit einer Dicke von bspw. 15 nm /10 nm /20 nm Dicke, gefolgt von bspw. 2,8 µm AlCu und einer optionalen, bspw. ca. 40 nm dicken TiN-Schicht. Die Abscheidungen erfolgen sequentiell in einem PVD-Tool (Physical Vapor Deposition) ohne Vakuumunterbrechung. Die lateralen Abmessungen der vierten Metallisierungslage M4c sind an der Stelle der zu erzeugenden Spule 421 jenen der Metallisierungslage M3c angepasst oder geringfügig größer als jene, an anderen Stellen sind sie beliebig (im Rahmen der Designregeln) wählbar. Es schließt sich die Strukturierung des Metallschichtstapels bspw. in einem chlorhaltigen Plasma-RIE-Prozess (Cl₂/BCl₃-Chemie) mit bspw. Endpunktsdetektion an.

Alternativ können danach erfolgen:
a) die Abscheidung und Strukturierung bekannter Passivierungsschutzschichten wie SiO₂/Si₃N₄, oder
b) die Abscheidung eines einebnenden Intermetalldielektrikums aus bspw. PECVD-SiO₂ (Plasma Enhanced Chemical Vapor Deposition) und HDP-SiO₂ (High Density Plasma) von ausreichender Gesamtdicke (hier: mind. 2,8 µm), dessen Planarisierung mittels CMP sowie die weitere Abscheidung eines einfachen PECVD-SiO₂ IMD's auf den erzeugten planen Untergrund. Deren Dicke wird gemäß der gewünschten Dicke der nachfolgenden Metall-Lage gewählt, die wiederum in Single-Damascene-Architektur erzeugt wird. Der Ablauf der Herstellungsschritte für eine optionale Metallisierungslage M5c in SD Architektur entspricht im Wesentlichen der Beschreibung für die Metallisierungslage M3c, wobei eine der Leitbahn 234 entsprechende Leitbahn 434 und ein dem Via 236 entsprechendes Via 436 erzeugt werden.

Wird die Prozessierung gemäß der genanten Option a) mit der Passivierungserzeugung beendet, so wurde eine integrierte Spule 421 erzeugt mit einer Gesamt-Wicklungshöhe von bspw. 4,0 µm, wie sie in klassischer Dual Damascene Architektur nur schwierig und unter hohem Kostenaufwand realisiert werden kann. Gleichzeitig können durch entsprechende Öffnungen 410 in der Passivierungsschicht von z.B. 60x80 µm² Aluminium-Pads 442 freigelegt werden, die für bekannte Bond- oder Kontaktierzwecke genutzt werden. Die Aluminiumpads sind ebenfalls in der Metallisierungslage M4c angeordnet. Damit bietet sich diese Kombination aus Damascene- und RIE-Architektur für die kostengünstige Erzeugung hochgütiger Spulen besonders an.

Bezüglich der Anordnung von Abschnitten a bis g der Leitbahnen 426, 430 bzw. 434 wird auf die Abschnitte A bis G der Leitbahnen 226, 230 bzw. 234 verwiesen, die oben an Hand der Figur 3 erläutert worden sind. Die weitere Prozessierung und Fertigstellung der Schaltung erfolgt mit den üblichen Methoden und Verfahren.

Figur 6 zeigt einen Querschnitt durch eine Metallisierung einer integrierten Schaltungsanordnung 510, die einen Kondensator 521 enthält. Die Kondensatoranordnung 521 erstreckt sich bspw. über sechs Metallisierungslagen 530 bis 580, die in dieser Reihenfolge unmittelbar aneinandergrenzen. Die Kondensatoranordnung enthält:
- eine im Vergleich zu den mittleren Leitstrukturen der Kondensatoranordnung 521 großflächige Leitstruktur 582 in der Metallisierungslage 530, wobei die Leitstruktur 582 gleichzeitig eine Bodenplatte und eine Anschlussplatte für vertikale Elektroden der Kondensatoranordnung 521 bildet,
- ein im Vergleich zu den mittleren Leitstrukturen der Kondensatoranordnung 521 großflächige Leitstruktur 584 in der Metallisierungslage 580, die bspw. die gleiche Fläche wie die Leitstruktur 582 hat und die die Deckplatte der Kondensatoranordnung bzw. die Anschlussplatte für vertikale Elektroden der Kondensatoranordnung 521 bildet,
- eine erste vertikale Teil-Elektrode aus drei sich in z-Richtung erstreckenden Leitstrukturen 600, 602 und 604, wobei diese Leitstrukturen 600, 602 und 604 in der genannten Reihenfolge in der Metallisierungslage 540, 550 bzw. 560 liegen und gleiche x-Positionen haben. Die Leitstruktur 600 grenzt an die Leitstruktur 582 an. Alle drei Leitstrukturen 600, 602 und 604 sind jeweils mehr als fünf mal so lang wie breit.
- eine zweite vertikale Teil-Elektrode aus drei sich in z-Richtung erstreckenden Leitstrukturen 610, 612 und 614, wobei diese Leitstrukturen 610, 612 und 614 in der genannten Reihenfolge in der Metallisierungslage 550, 560 bzw. 570 liegen und gleiche x-Positionen haben. Die Leitstruktur 614 grenzt an die Leitstruktur 584 an. Alle drei Leitstrukturen 610, 612 und 614 sind jeweils mehr als fünf mal so lang wie breit.
- eine dritte vertikale Teil-Elektrode aus drei sich in z-Richtung erstreckenden Leitstrukturen 620, 622 und 624, wobei diese Leitstrukturen 620, 622 und 624 in der genannten Reihenfolge in der Metallisierungslage 540, 550 und 560 liegen und gleiche x-Positionen haben. Die Leitstruktur 620 grenzt an die Leitstruktur 582 an. Alle drei Leitstrukturen 620, 622 und 624 sind jeweils mehr als fünf mal so lang wie breit.
- eine vierte vertikale Teil-Elektrode aus drei sich in z-Richtung erstreckenden Leitstrukturen 630, 632 und 634, wobei diese Leitstrukturen 630, 632 und 634 in der genannten Reihenfolge in der Metallisierungslage 550, 560 bzw. 570 liegen und gleiche x-Positionen haben. Die Leitstruktur 634 grenzt an die Leitstruktur 584 an. Alle drei Leitstrukturen 630, 632 und 634 sind jeweils mehr als fünf mal so lang wie breit.
- eine fünfte vertikale Teil-Elektrode aus drei sich in z-Richtung erstreckenden Leitstrukturen 640, 642 und 6424, wobei diese Leitstrukturen 640, 642 und 644 in der genannten Reihenfolge in der Metallisierungslage 540, 550 und 560 liegen und gleiche x-Positionen haben. Die Leitstruktur 640 grenzt an die Leitstruktur 582 an. Alle drei Leitstrukturen 640, 642 und 644 sind jeweils mehr als fünf mal so lang wie breit.
- eine sechste vertikale Teil-Elektrode aus drei sich in z-Richtung erstreckenden Leitstrukturen 650, 652 und 654, wobei diese Leitstrukturen 650, 652 und 654 in der genannten Reihenfolge in der Metallisierungslage 550, 560 bzw. 570 liegen und gleiche x-Positionen haben. Die Leitstruktur 654 grenzt an die Leitstruktur 584 an. Alle drei Leitstrukturen 650, 652 und 654 sind jeweils mehr als fünf mal so lang wie breit.

Die erste vertikale Elektrode, die dritte vertikale Elektrode und die fünfte vertikale Elektrode, die Teile einer ersten Hauptelektrode des Kondensators bilden, sind demzufolge mit der zweiten vertikalen Elektrode, mit der vierten vertikalen Elektrode und mit der sechsten vertikalen Elektrode verzahnt, die Teile einer zweiten Hauptelektrode des Kondensators 521 bilden. Zwischen den vertikalen Elektroden befindet sich ein nicht dargestelltes Isoliermaterial, z.B. Siliziumdioxid oder ein high k Material mit einer relativen Dielektrizitätskonstante größer als 4.

Bei anderen Ausführungsbeispielen erstrecken sich die mittleren Leitstrukturen in x-Richtung. Es werden mehr oder auch weniger als sechs Metallisierungslagen für die Kondensatoranordnung verwendet. Auch die Anzahl der vertikalen Elektroden wird verändert und liegt bspw. zwischen zwei und 100.

Im Ausführungsbeispiel sind die in Figur 6 dargestellten Leitstrukturen mit einer einfach Damascene-Technik aus Kupfer bzw. einer Kupferlegierung hergestellt. Bei anderen Ausführungsbeispielen wird jedoch ein anderes Metall und eine andere Herstellungstechnik verwendet, z.B. eine Aluminiumlegierung, die mit Hilfe von RIE-Verfahren strukturiert wird.

Die an Hand der Figuren 3 bis 6 erläuterten passiven Bauelemente lassen sich sowohl in herkömmliche Metallisierungen mit sich abwechselnden Leitbahnlagen und Vialagen als auch in neuartige Metallisierungen mit mehreren aufeinanderfolgenden Leitbahnlagen integrieren.

## Patentansprüche

1. Integrierte Schaltungsanordnung (10),
mit einem Substrat (20), in dem eine Vielzahl integrierter Halbleiterbauelemente angeordnet sind,
mit einer substratnahen Verdrahtungs-Leitbahn (58), einer mittleren Verdrahtungs-Leitbahn(68) und einer substratfernen Verdrahtungs-Leitbahn (76), die in dieser Reihenfolge mit zunehmendem Abstand zu dem Substrat (20) angeordnet sind,
die Verdrahtungs-Leitbahnen (58, 68, 76) enthalten jeweils eine ebene Bodenfläche und eine ebene Deckfläche, die an ein Dielektrikum angrenzen,
die Bodenfläche der substratfernen Verdrahtungs-Leitbahn (76) erstreckt sich in einer Ebene, in der sich auch die Deckfläche der mittleren Verdrahtungs-Leitbahn (68) erstreckt oder die Bodenfläche der substratfernen Verdrahtungs-Leitbahn (76) erstreckt sich in einer Ebene, die näher am Substrat (20) liegt als eine Ebene, in der sich die Deckfläche der mittleren Verdrahtungs-Leitbahn (68) erstreckt, und
die Bodenfläche der mittleren Verdrahtungs-Leitbahn (68) erstreckt sich in einer Ebene, in der sich auch die Deckfläche der substratnahen Verdrahtungs-Leitbahn (58) erstreckt oder die Bodenfläche der mittleren Verdrahtungs-Leitbahn (68) erstreckt sich in einer Ebene, die näher am Substrat (20) liegt als eine Ebene, in der sich die Deckfläche der substratnahen Verdrahtungs-Leitbahn (58) erstreckt,
wobei die Verdrahtungs-Leitbahnen (58, 68, 76) jeweils einen mittleren Abschnitt (AB1, AB2) haben, an den kein Via und keine Leitbahn grenzt, Karakterisiert dadurch dass die Bodenfläche der substratfernen Verdrahtungs-Leitbahn von einer Ebene, in der sich die Deckfläche der mittleren Verdrahtungs-Leitbahn erstreckt, maximal einen Abstand hat, der weniger als zwanzig Prozent der Höhe der substratfernen Verdrahtungs-Leitbahn beträgt.

2. Integrierte Schaltungsanordnung (210, 310, 510) nach Anspruch 1, **gekennzeichnet durch**, eine substratnahe Bauelement-Leitbahn (226, 324, 610), eine mittlere Bauelement-Leitbahn (230, 328, 612) und eine substratferne Bauelement-Leitbahn (234, 334, 614), die in dieser Reihenfolge mit zunehmendem Abstand zu dem Substrat (220, 320) angeordnet sind und in einem Bauelementabschnitt einen gleichen Verlauf haben,
die Bauelement-Leitbahnen enthalten in dem Bauelementabschnitt jeweils eine ebene Bodenfläche und eine ebene Deckfläche,
in dem Bauelementabschnitt sind die Bauelemente-Leitbahnen jeweils mindestens fünf mal so lang wie breit oder mindestens zehn mal so lang wie breit,
in dem Bauelementabschnitt grenzt die Deckfläche der mittleren Bauelement-Leitbahn (230, 328, 612) an die Bodenfläche der substratfernen Bauelement-Leitbahn (234, 334, 614),
in dem Bauelementabschnitt grenzt die Bodenfläche der mittleren Bauelement-Leitbahn (230, 328, 612) an die Deckfläche der substratnahen Bauelement-Leitbahn (226, 324, 610),
die Deckflächen der substratfernen Verdrahtungs-Leitbahn (76) und der substratfernen Bauelement-Leitbahn (234, 334, 614) erstrecken sich in einer Ebene,
die Bodenflächen der substratfernen Verdrahtungs-Leitbahn (76) und der substratfernen Bauelement-Leitbahn (234, 334, 614) erstrecken sich in einer Ebene,
die Deckflächen der mittleren Verdrahtungs-Leitbahn (68) und der mittleren Bauelement-Leitbahn (230, 328, 612) erstrecken sich in einer Ebene,
die Bodenflächen der mittleren Verdrahtungs-Leitbahn (68) und der mittleren Bauelement-Leitbahn (230, 328, 612) erstrecken sich in einer Ebene,
die Deckflächen der substratnahen Verdrahtungs-Leitbahn (58) und der substratnahen Bauelement-Leitbahn (226, 324, 610) erstrecken sich in einer Ebene,
die Bodenflächen der substratnahen Verdrahtungs-Leitbahn (58) und der substratnahen Bauelement-Leitbahn (226, 324, 610) erstrecken sich in einer Ebene.

3. Schaltungsanordnung (210) nach Anspruch 2, **dadurch gekennzeichnet, dass** der Bauelementabschnitt (A bis G) eine Windung oder mindestens zwei Windungen einer Spule (221) bildet.

4. Schaltungsanordnung (310) nach Anspruch 2, **dadurch gekennzeichnet, dass** der Bauelementabschnitt eine Seitenwand einer Koaxialleitung (321) bildet

5. Schaltungsanordnung (510) nach Anspruch 2, **dadurch gekennzeichnet, dass** der Bauelementabschnitt eine Kondensatorelektrode oder einen Teil einer Kondensatorelektrode bildet, wobei die Kondensatorelektrode oder der Teil vorzugsweise eine Länge größer als zehn Mikrometer oder größer als fünfzig Mikrometer hat.

6. Schaltungsanordnung (10) nach einem der Ansprüche 1 bis 5, **dadurch gekennzeichnet, dass** die Deckfläche der mittleren Bauelement-Leitbahn (230) entlang des gesamten Bauelementabschnitts (A bis G) an die Bodenfläche der substratfernen Bauelement-Leitbahn (234) grenzt,
und/oder dass die Bodenfläche der mittleren Bauelement-Leitbahn (230) entlang des gesamten Bauelementabschnitts (A bis G) oder entlang einer Länge von mindestens 50 Mikrometern an die Deckfläche der substratnahen Bauelement-Leitbahn (226) grenzt.

7. Schaltungsanordnung (10) nach einem der vorhergehenden Ansprüche, **dadurch gekennzeichnet, dass** die Leitbahnen jeweils aus Aluminium bestehen oder mindestens 60 Atomprozent Aluminium enthalten, oder dass die Leitbahnen jeweils aus Kupfer oder aus mindestens 60 Atomprozent Kupfer bestehen.

8. Schaltungsanordnung (10) nach einem der vorhergehenden Ansprüche, **dadurch gekennzeichnet, dass** es mindestens noch eine weitere Leitstrukturlage gibt, die substratferner als die substratferne Leitbahn (76) angeordnet ist.

9. Schaltungsanordnung (10) nach einem der vorhergehenden Ansprüche, **dadurch gekennzeichnet, dass** es mindestens noch eine Leitstrukturlage (22) oder mindestens noch zwei Leitstrukturlagen (22) zwischen der substratnahen Leitbahn (58) und dem Substrat (20) gibt.

10. Integrierte Schaltungsordnung (210, 310, 410, 510) nach Anspruch 1, **gekennzeichnet durch**, eine substratnahe Bauelement-Leitbahn (226, 324, 426, 610) und eine substratferne Bauelement-Leitbahn (230, 328, 430, 612), die in dieser Reihenfolge mit zunehmendem Abstand zu dem Substrat (220, 320, 420) angeordnet sind und in einem Bauelementabschnitt einen gleichen Verlauf haben,
die Bauelement-Leitbahnen enthalten in dem Bauelementabschnitt jeweils eine ebene Bodenfläche und eine ebene Deckfläche,
in dem Bauelementabschnitt sind die Bauelemente-Leitbahnen jeweils mindestens fünf mal so lang wie breit oder mindestens zehn mal so lang wie breit,
in dem Bauelementabschnitt grenzt die Deckfläche der substratnahen Bauelement-Leitbahn an die Bodenfläche der substratfernen Bauelement-Leitbahn,
entweder gilt:
die Deckflächen der substratfernen Verdrahtungs-Leitbahn und der substratfernen Bauelement-Leitbahn erstrecken sich in einer Ebene,
die Bodenflächen der substratfernen Verdrahtungs-Leitbahn und der substratfernen Bauelement-Leitbahn erstrecken sich in einer Ebene,
die Deckflächen der mittleren Verdrahtungs-Leitbahn und der substratnahen Bauelement-Leitbahn erstrecken sich in einer Ebene,
die Bodenflächen der mittleren Verdrahtungs-Leitbahn und der substratnahen Bauelement-Leitbahn erstrecken sich in einer Ebene,
oder es gilt:
die Deckflächen der mittleren Verdrahtungs-Leitbahn und der substratfernen Bauelement-Leitbahn (430) erstrecken sich in einer Ebene,
die Bodenflächen der mittleren Verdrahtungs-Leitbahn und der substratfernen Bauelement-Leitbahn erstrecken sich in einer Ebene,
die Deckflächen der substratnahen Verdrahtungs-Leitbahn und der substratnahen Bauelement-Leitbahn erstrecken sich in einer Ebene,
die Bodenflächen der substratnahen Verdrahtungs-Leitbahn und der substratnahen Bauelement-Leitbahn erstrecken sich in einer Ebene.

11. Schaltungsanordnung (210) nach Anspruch 10, **dadurch gekennzeichnet, dass** der Bauelementabschnitt eine Windung oder mindestens zwei Windungen einer Spule (221) bildet, oder dass der Bauelementabschnitt eine Seitenwand einer Koaxialleitung (321) bildet, oder dass der Bauelementabschnitt eine Kondensatorelektrode oder einen Teil einer Kondensatorelektrode bildet, wobei die Kondensatorelektrode oder der Teil vorzugsweise eine Länge größer als zehn Mikrometer oder größer als fünfzig Mikrometer hat

12. Schaltungsanordnung nach Anspruch 10 oder 11, **dadurch gekennzeichnet, dass** die Leitbahnen jeweils aus Aluminium bestehen oder mindestens 60 Atomprozent Aluminium enthalten, oder dass die Leitbahnen jeweils aus Kupfer oder aus mindestens 60 Atomprozent Kupfer bestehen,
oder dass die substratfernen Leitbahnen aus Aluminium bestehen oder mindestens 60 Atomprozent Aluminium enthalten und die substratnahen Leitbahnen aus Kupfer oder aus mindestens 60 Atomprozent Kupfer bestehen.

13. Schaltungsanordnung (10) nach einem der Ansprüche 10 bis 12, **dadurch gekennzeichnet, dass** die Deckfläche der substratnahen Bauelement-Leitbahn entlang des gesamten Bauelementabschnitts oder entlang einer Länge von mindestens 50 Mikrometern an die Bodenfläche der substratfernen Bauelement-Leitbahn grenzt.

14. Schaltungsanordnung nach einem der vorhergehenden Ansprüche, **dadurch gekennzeichnet, dass** der mittlere Abschnitt jeweils mindestens ein Drittel der Länge der Verdrahtungs-Leitbahn von jedem Ende der Verdrahtungs-Leitbahn entfernt ist.

15. Schaltungsanordnung nach einem der Ansprüche 1 bis 14, **dadurch gekennzeichnet, dass** die Bodenfläche der substratfernen Leitbahn von einer Ebene, in der sich die Deckfläche der mittleren Leitbahn erstreckt, maximal einen Abstand hat, der weniger als zehn Prozent der Höhe der substratfernen Leitbahn beträgt,
und/oder dass die Bodenfläche der mittleren Leitbahn von einer Ebene, in der sich die Deckfläche der substratnahen Leitbahn erstreckt, maximal einen Abstand hat, der weniger als zwanzig Prozent oder weniger als zehn Prozent der Höhe der mittleren Leitbahn beträgt.

16. Schaltungsanordnung nach Anspruch 15, **dadurch gekennzeichnet, dass** die gesamte Bodenfläche der substratfernen Leitbahn den genannten Abstand hat,
und/oder dass die gesamte Bodenfläche der mittleren Leitbahn den genannten Abstand hat.

17. Schaltungsanordnung nach einem der vorhergehenden Ansprüche, **dadurch gekennzeichnet, dass** die Leitstrukturen einer Leitstrukturlage innerhalb dieser Leitstrukturlage eine Höhe haben, die sich um weniger als zwanzig Prozent oder um weniger als zehn Prozent der maximalen Höhe dieser Leitstrukturlage ändert.

18. Verfahren zur Herstellung einer integrierten Schaltungsanordnung
mit einem Substrat (20), in dem eine Vielzahl integrierter Halbleiterbauelemente angeordnet sind,
mit einer substratnahen Verdrahtungs-Leitbahn (58), einer mittleren Verdrahtungs-Leitbahn(68) und einer substratfernen Verdrahtungs-Leitbahn (76), die in dieser Reihenfolge mit zunehmendem Abstand zu dem Substrat (20) angeordnet sind,
die Verdrahtungs-Leitbahnen (58, 68, 76) enthalten jeweils eine ebene Bodenfläche und eine ebene Deckfläche, die an ein Dielektrikum angrenzen,
die Bodenfläche der substratfernen Verdrahtungs-Leitbahn (76) erstreckt sich in einer Ebene, in der sich auch die Deckfläche der mittleren Verdrahtungs-Leitbahn (68) erstreckt oder die Bodenfläche der substratfernen Verdrahtungs-Leitbahn (76) erstreckt sich in einer Ebene, die näher am Substrat (20) liegt als eine Ebene, in der sich die Deckfläche der mittleren Verdrahtungs-Leitbahn (68) erstreckt, und
die Bodenfläche der mittleren Verdrahtungs-Leitbahn (68) erstreckt sich in einer Ebene, in der sich auch die Deckfläche der substratnahen Verdrahtungs-Leitbahn (58) erstreckt oder die Bodenfläche der mittleren Verdrahtungs-Leitbahn (68) erstreckt sich in einer Ebene, die näher am Substrat (20) liegt als eine Ebene, in der sich die Deckfläche der substratnahen Verdrahtungs-Leitbahn (58) erstreckt,
wobei die Verdrahtungs-Leitbahnen (58, 68, 76) jeweils einen mittleren Abschnitt (AB1, AB2) haben,
an den kein Via und keine Leitbahn grenzt,
**dadurch gekennzeichnet, dass** entweder a) die Leitbahnen jeweils mit einem einfachen Damascene-Verfahren hergestellt werden,
oder dass alternativ b) die substratferne Leitbahn mit einem subtraktiven Verfahren strukturiert wird, insbesondere mit reaktivem Ionenätzen,
und dass die mittlere Leitbahn oder die substratnahe Leitbahn mit einem Damascene-Verfahren strukturiert wird, Karakterisiert **dadurch** dass die Bodenfläche der substratfernen Verdrahtungs-Leitbahn von einer Ebene, in der sich die Deckfläche der mittleren Verdrahtungs-Leitbahn erstreckt, maximal einen Abstand hat, der weniger als zwanzig Prozent der Höhe der substratfernen Verdrahtungs-Leitbahn beträgt.

## Claims

1. Integrated circuit arrangement (10),
having a substrate (20) with a multiplicity of integrated semiconductor components arranged therein, having a wiring interconnect (58) near to the substrate, a middle wiring interconnect (68) and a wiring interconnect (76) remote from the substrate, which are arranged in this order at increasing distance from the substrate (20),
the wiring interconnects (58, 68, 76) each contain a planar bottom area and a planar top area which adjoin a dielectric,
the bottom area of the wiring interconnect (76) remote from the substrate extends in a plane in which the top area of the middle wiring interconnect (68) also extends, or the bottom area of the wiring interconnect (76) remote from the substrate extends in a plane which lies nearer to the substrate (20) than a plane in which the top area of the middle wiring interconnect (68) extends, and
the bottom area of the middle wiring interconnect (68) extends in a plane in which the top area of the wiring interconnect (58) near to the substrate extends, or the bottom area of the middle wiring interconnect (68) extends in a plane which lies nearer to the substrate (20) than a plane in which the top area of the wiring interconnect (58) near to the substrate extends,
the wiring interconnects (58, 68, 76) each having a middle section (AB1, AB2) that is not adjoined by any via and any interconnect, **characterized in that** the bottom area of the wiring interconnect remote from the substrate is maximally at a distance from a plane in which the top area of the middle wiring interconnect extends which amounts to less than 20 per cent of the height of the wiring interconnect remote from the substrate.

2. Integrated circuit arrangement (210, 310, 510) according to Claim 1, **characterized by** a component interconnect (226, 324, 610) near to the substrate, a middle component interconnect (230, 328, 612) and a component interconnect (234, 334, 614) remote from the substrate, which are arranged in this order at increasing distance from the substrate (220, 320) and have an identical course in a component section,
the component interconnects each contain a planar bottom area and a planar top area in the component section,
in the component section the component interconnects each have a length at least five times greater than their width or a length at least ten times greater than their width,
in the component section the top area of the middle component interconnect (230, 328, 612) adjoins the bottom area of the component interconnect (234, 334, 614) remote from the substrate,
in the component section the bottom area of the middle component interconnect (230, 328, 612) adjoins the top area of the component interconnect (226, 324, 610) near to the substrate,
the top areas of the wiring interconnect (76) remote from the substrate and of the component interconnect (234, 334, 614) remote from the substrate extend in one plane,
the bottom areas of the wiring interconnect (76) remote from the substrate and of the component interconnect (234, 334, 614) remote from the substrate extend in one plane,
the top areas of the middle wiring interconnect (68) and of the middle component interconnect (230, 328, 612) extend in one plane,
the bottom areas of the middle wiring interconnect (68) and of the middle component interconnect (230, 328, 612) extend in one plane,
the top areas of the wiring interconnect (58) near to the substrate and of the component interconnect (226, 324, 610) near to the substrate extend in one plane,
the bottom areas of the wiring interconnect (58) near to the substrate and of the component interconnect (226, 324, 610) near to the substrate extend in one plane.

3. Circuit arrangement (210) according to Claim 2, **characterized in that** the component section (A to G) forms one turn or at least two turns of a coil (221).

4. Circuit arrangement (310) according to Claim 2, **characterized in that** the component section forms a sidewall of a coaxial line (321).

5. Circuit arrangement (510) according to Claim 2, **characterized in that** the component section forms a capacitor electrode or a part of a capacitor electrode, the capacitor electrode or the part preferably having a length of greater than ten micrometers or greater than fifty micrometers.

6. Circuit arrangement (10) according to one of Claims 1 to 5, **characterized in that** the top area of the middle component interconnect (230) adjoins the bottom area of the component interconnect (234) remote from the substrate along the entire component section (A to G), and/or **in that** the bottom area of the middle component interconnect (230) adjoins the top area of the component interconnect (226) near to the substrate along the entire component section (A to G) or along a length of at least 50 micrometers.

7. Circuit arrangement (10) according to one of the preceding claims, **characterized in that** the interconnects each comprise aluminium or contain at least 60 atomic per cent of aluminium, or **in that** the interconnects each comprise copper or at least 60 atomic per cent of copper.

8. Circuit arrangement (10) according to one of the preceding claims, **characterized in that** there is at least yet another conductive structure level arranged more remotely from the substrate than the interconnect (76) remote from the substrate.

9. Circuit arrangement (10) according to one of the preceding claims, **characterized in that** there is at least one other conductive structure level (22) or at least two other conductive structure levels (22) between the interconnect (58) near to the substrate and the substrate (20).

10. Integrated circuit arrangement (210, 310, 410, 510) according to Claim 1, **characterized by** a component interconnect (226, 324, 426, 610) near to the substrate and a component interconnect (230, 328, 430, 612) remote from the substrate, which are arranged in this order at increasing distance from the substrate (220, 320, 420) and have an identical course in a component section,
the component interconnects each contain a planar bottom area and a planar top area in the component section,
in the component section the component interconnects each have a length at least five times greater than their width or a length at least ten times greater than their width,
in the component section the top area of the component interconnect near to the substrate adjoins the bottom area of the component interconnect remote from the substrate,
either the following holds true:
the top areas of the wiring interconnect remote from the substrate and of the component interconnect remote from the substrate extend in one plane,
the bottom areas of the wiring interconnect remote from the substrate and of the component interconnect remote from the substrate extend in one plane,
the top areas of the middle wiring interconnect and of the component interconnect near to the substrate extend in one plane,
the bottom areas of the middle wiring interconnect and
of the component interconnect near to the substrate extend in one plane,
or the following holds true:
the top areas of the middle wiring interconnect and of the component interconnect (430) remote from the substrate extend in one plane,
the bottom areas of the middle wiring interconnect and of the component interconnect remote from the substrate extend in one plane,
the top areas of the wiring interconnect near to the substrate and of the component interconnect near to the substrate extend in one plane,
the bottom areas of the wiring interconnect near to the substrate and of the component interconnect near to the substrate extend in one plane.

11. Circuit arrangement (210) according to Claim 10, **characterized in that** the component section forms one turn or at least two turns of a coil (221), or **in that** the component section forms a sidewall of a coaxial line (321), or **in that** the component section forms a capacitor electrode or a part of a capacitor electrode, the capacitor electrode or the part preferably having a length of greater than ten micrometers or greater than fifty micrometers.

12. Circuit arrangement according to Claim 10 or 11, **characterized in that** the interconnects each comprise aluminium or contain at least 60 atomic per cent of aluminium, or **in that** the interconnects each comprise copper or at least 60 atomic per cent of copper,
or **in that** the interconnects remote from the substrate comprise aluminium or contain at least 60 atomic per cent of aluminium and the interconnects near to the substrate comprise copper or at least 60 atomic per cent of copper.

13. Circuit arrangement (10) according to one of Claims 10 to 12, **characterized in that** the top area of the component interconnect near to the substrate adjoins the bottom area of the component interconnect remote from the substrate along the entire component section or along a length of at least 50 micrometers.

14. Circuit arrangement according to one of the preceding claims, **characterized in that** the middle section in each case is at least a third of the length of the wiring interconnect away from each end of the wiring interconnect.

15. Circuit arrangement according to one of Claims 1 to 14, **characterized in that** the bottom area of the interconnect remote from the substrate is maximally at a distance from a plane in which the top area of the middle interconnect extends which amounts to less than 10 per cent of the height of the interconnect remote from the substrate,
and/or **in that** the bottom area of the middle interconnect is maximally at a distance from a plane in which the top area of the interconnect near to the substrate extends which amounts to less than 20 per cent or less than 10 per cent of the height of the middle interconnect.

16. Circuit arrangement according to Claim 15, **characterized in that** the entire bottom area of the interconnect remote from the substrate is at said distance,
and/or **in that** the entire bottom area of the middle interconnect is at said distance.

17. Circuit arrangement according to one of the preceding claims, **characterized in that** the conductive structures of a conductive structure level have within said conductive structure level a height that changes by less than 20 per cent or by less than 10 per cent of the maximum height of said conductive structure level.

18. Method for producing an integrated circuit arrangement
having a substrate (20) with a multiplicity of integrated semiconductor components arranged therein, having a wiring interconnect (58) near to the substrate, a middle wiring interconnect (68) and a wiring interconnect (76) remote from the substrate, which are arranged in this order at increasing distance from the substrate (20),
the wiring interconnects (58, 68, 76) each contain a planar bottom area and a planar top area which adjoin a dielectric,
the bottom area of the wiring interconnect (76) remote from the substrate extends in a plane in which the top area of the middle wiring interconnect (68) also extends, or the bottom area of the wiring interconnect (76) remote from the substrate extends in a plane which lies nearer to the substrate (20) than a plane in which the top area of the middle wiring interconnect (68) extends, and
the bottom area of the middle wiring interconnect (68) extends in a plane in which the top area of the wiring interconnect (58) near to the substrate extends, or the bottom area of the middle wiring interconnect (68) extends in a plane which lies nearer to the substrate (20) than a plane in which the top area of the wiring interconnect (58) near to the substrate extends,
the wiring interconnects (58, 68, 76) each having a middle section (AB1, AB2) that is not adjoined by any via and any interconnect,
**characterized in that** either a) the interconnects are in each case produced by means of a single damascene method,
or **in that** alternatively b) the interconnect remote from the substrate is patterned by means of a subtractive method, in particular by means of reactive ion etching,
and **in that** the middle interconnect or the interconnect near to the substrate is patterned by means of a damascene method, **characterized in that** the bottom area of the wiring interconnect remote from the substrate is maximally at a distance from a plane in which the top area of the middle wiring interconnect extends which amounts to less than 20 per cent of the height of the wiring interconnect remote from the substance.

## Revendications

1. Circuit (10) intégré,
comprenant un substrat (20), dans lequel sont disposés une pluralité de composants intégrés à semiconducteurs,
comprenant une piste (58) conductrice de câblage proche du substrat, une piste (68) conductrice de câblage intermédiaire et une piste (76) conductrice de câblage éloignée du substrat, qui sont disposées dans cet ordre à une distance croissante du substrat (20),
les pistes (58, 68, 76) conductrices de câblage comprenant, respectivement, une surface plane de fond et une surface plane de recouvrement, qui sont voisines d'un diélectrique,
la surface de fond de la piste (76) conductrice de câblage éloignée du substrat s'étend dans un plan, dans lequel s'étend aussi la surface de recouvrement de la piste (68) conductrice de câblage intermédiaire ou la surface de fond de la piste (76) conductrice de câblage éloignée du substrat s'étend dans un plan, qui est plus proche du substrat (20) qu'un plan dans lequel s'étend la surface de recouvrement de la piste (68) conductrice de câblage intermédiaire, et
la surface de fond de la piste (68) conductrice de câblage intermédiaire s'étend dans un plan, dans lequel s'étend aussi la surface de recouvrement de la piste (58) conductrice de câblage proche du substrat ou la surface de fond de la piste (68) conductrice de câblage intermédiaire s'étend dans un plan, qui est plus proche du substrat (20) qu'un plan dans lequel s'étend la surface de recouvrement de la piste (68) conductrice de câblage proche du substrat,
dans lequel les pistes (58, 68, 76) de câblage ont respectivement un segment (AB1, AB2) médian, qui n'est pas voisin de traversées et de pistes conductrices, **caractérisé en ce que** la surface de fond de la piste conductrice de câblage éloignée du substrat est à une distance maximum d'un plan, dans lequel s'étend la surface de recouvrement de la piste conductrice de câblage intermédiaire, qui représente moins vingt pour-cent de la hauteur de la piste conductrice de câblage éloignée du substrat.

2. Circuit (210, 310, 510) intégré suivant la revendication 1, **caractérisé par** une piste (226, 324, 610) conductrice de composant proche du substrat, par une piste (230, 328, 612) conductrice de composant intermédiaire et par une piste (234, 334, 614) de composant éloignée du substrat, qui sont disposées dans cet ordre à une distance croissante du substrat (220, 320) et ont un même tracé dans un segment de composant, les pistes conductrices de composant contenant dans le segment de composant, respectivement, une surface plane de fond et une surface plane de recouvrement,
dans le segment de composant, les pistes conductrices de composant sont respectivement au moins cinq fois aussi longues que larges ou au moins dix fois aussi longues que larges,
dans le segment de composant, la surface de recouvrement de la piste (230, 328, 612) conductrice de composant intermédiaire est voisine de la surface de fond de la piste (234, 334, 614) conductrice de composant éloignée du substrat,
dans la section de composant, la surface de fond de la piste (230, 328, 612) conductrice de composant intermédiaire est voisine de la surface de recouvrement de la piste (226, 324, 610) conductrice de composant proche du substrat,
les surfaces de recouvrement de la piste (76) conductrice de câblage éloignée du substrat et de la piste (234, 334, 614) conductrice de composant éloignée du substrat s'étendent dans un plan,
les surfaces de fond de la piste (76) conductrice de câblage éloignée du substrat et de la piste (234, 334, 614) conductrice de composant éloignée du substrat s'étendent dans un plan,
les surfaces de recouvrement de la piste (68) conductrice de câblage intermédiaire et de la piste (230, 328, 612) conductrice de composant intermédiaire s'étendent dans un plan,
les surfaces de fond de la piste (68) conductrice de câblage intermédiaire et de la piste (230, 328, 612) conductrice de composant intermédiaire s'étendent dans un plan,
les surfaces de recouvrement de la piste (58) conductrice de câblage proche du substrat et de la piste (230, 328, 612) conductrice de composant intermédiaire s'étendent dans un plan,
les surfaces de fond de la piste (58) conductrice de câblage proche du substrat et de la piste (230, 328, 612) conductrice de composant intermédiaire s'étendent dans un plan.

3. Circuit (210) suivant la revendication 2, **caractérisé en ce que** le segment (A à G) de composant forme une spire ou au moins deux spires d'une bobine (221).

4. Circuit (310) suivant la revendication 2, **caractérisé en ce que** le segment de composant forme une paroi latérale d'une ligne (321) coaxiale.

5. Circuit (510) suivant la revendication 2, **caractérisé en ce que** le segment de composant forme une électrode de condensateur ou une partie d'une électrode de condensateur, l'électrode de condensateur ou la partie ayant, de préférence, une longueur plus grande que dix microns ou plus grande que cinquante microns.

6. Circuit (10) suivant l'une des revendications 1 à 5, **caractérisé en ce que** la surface de recouvrement de la piste (230) conductrice de composant intermédiaire est voisine le long de tout le segment (A à G) de composant de la surface de fond de la piste (234) conductrice de composant éloignée du substrat,
et/ou **en ce que** la surface de fond de la piste (230) conductrice de composant intermédiaire est voisine le long de tout le segment (A à G) de composant ou le long d'une longueur d'au moins 50 microns de la surface de recouvrement de la piste (226) conductrice de composant proche du substrat.

7. Circuit (10) suivant l'une des revendications précédentes, **caractérisé en ce que** les pistes conductrices sont, respectivement, en aluminium et contiennent au moins 60 pour-cent en atome d'aluminium ou **en ce que** les pistes conductrices sont, respectivement, en cuivre ou en au moins 60 pour-cent en atome de cuivre.

8. Circuit (10) suivant l'une des revendications précédentes, **caractérisé en ce qu'**il y a au moins encore une autre couche de structure conductrice, qui est plus éloignée du substrat que ne l'est la piste (76) conductrice éloignée du substrat.

9. Circuit (10) suivant l'une des revendications précédentes, **caractérisé en ce qu'**il y a au moins encore une couche (22) de structure conductrice ou au moins encore deux couches (22) de structure conductrices entre la piste (58) conductrice proche du substrat et le substrat (20).

10. Circuit (210, 310, 410, 510) intégré suivant la revendication 1, **caractérisé par** une piste (226, 324, 426, 610) conductrice de composant proche du substrat et une piste (230, 328, 430, 612) conductrice de composant éloignée du substrat, qui sont disposées dans cet ordre à une distance croissante du substrat (220, 320, 420) et qui ont un même tracé dans un segment de composant,
les pistes conductrices de composant contiennent dans le segment de composant, respectivement, une surface plane de fond et une surface plane de recouvrement,
dans le segment de composant, les pistes conductrices de composant sont respectivement au moins cinq fois aussi grandes que larges ou au moins dix fois aussi longues que larges,
dans le segment de composant, la surface de recouvrement de la piste conductrice de composant proche du substrat est voisine de la surface de fond de la piste conductrice de composant éloignée du substrat,
ou bien :
les surfaces de recouvrement de la piste conductrice de câblage éloignée du substrat et de la piste conductrice de composant éloignée du substrat s'étendent dans un plan,
les surfaces de fond de la piste conductrice de câblage éloignée du substrat et de la piste conductrice de composant éloignée du substrat s'étendent dans un plan,
les surfaces de recouvrement de la piste conductrice de câblage intermédiaire et de la piste conductrice de composant proche du substrat s'étendent dans un plan,
les surfaces de fond de la piste conductrice de câblage intermédiaire et de la piste conductrice de composant proche s'étendent dans un plan,
ou bien :
les surfaces de recouvrement de la piste conductrice de câblage intermédiaire et de la piste (430) conductrice de composant éloignée du substrat s'étendent dans un plan,
les surfaces de fond de la piste conductrice de câblage intermédiaire et de la piste conductrice de composant éloignée s'étendent dans un plan,
les surfaces de recouvrement de la piste conductrice de câblage proche du substrat et de la piste conductrice de composant proche du substrat s'étendent dans un plan,
les surfaces de fond de la piste conductrice de câblage proche du substrat et de la piste conductrice de composant proche du substrat s'étendent dans un plan.

11. Circuit (210) suivant la revendication 10, **caractérisé en ce que** le segment de composant forme une spire ou au moins deux spires d'une bobine (221) ou **en ce que** le segment de composant forme une paroi latérale d'une ligne (321) coaxiale ou **en ce que** le segment de composant forme une électrode de condensateur ou une partie d'une électrode de condensateur, l'électrode de condensateur ou la partie ayant, de préférence, une longueur plus grande que dix microns ou plus grande que cinquante microns.

12. Circuit suivant la revendication 10 ou 11, **caractérisé en ce que** les pistes conductrices sont, respectivement, en aluminium ou contiennent au moins 60 pour-cent en atome d'aluminium ou **en ce que** les pistes conductrices sont, respectivement, en cuivre ou en au moins 60 pour-cent en atome de cuivre,
ou **en ce que** les pistes conductrices éloignées du substrat sont en aluminium ou contiennent au moins 60 pour-cent en atome d'aluminium et les pistes conductrices proches du substrat sont en cuivre ou en au moins 60 pour-cent en atome de cuivre.

13. Circuit (10) suivant l'une des revendications 10 à 12, **caractérisé en ce que** la surface de recouvrement de la piste conductrice de composant proche du substrat est voisine le long de tout le segment de composant ou le long d'une longueur d'au moins 50 microns de la surface de fond de la piste conductrice de composant éloignée du substrat.

14. Circuit suivant l'une des revendications précédentes, **caractérisé en ce que** le segment intermédiaire est éloignée de chaque extrémité de la piste conductrice de câblage, respectivement d'au moins un tiers de la longueur de la piste conductrice de câblage.

15. Circuit suivant l'une des revendications 1 à 14, **caractérisé en ce que** la surface de fond de la piste conductrice éloignée du substrat est à une distance maximum d'un plan dans lequel s'étend la surface de recouvrement de la piste conductrice intermédiaire, qui représente moins de dix pour-cent de la hauteur de la piste conductrice éloignée du substrat,
et/ou **en ce que** la surface de fond de la piste conductrice intermédiaire est à une distance maximum d'un plan dans lequel s'étend la surface de recouvrement de la piste conductrice proche du substrat, qui représente moins vingt pour-cent ou moins de dix pour-cent de la hauteur de la piste conductrice intermédiaire.

16. Circuit suivant la revendication 15, **caractérisé en ce que** toute la surface de fond de la piste conductrice éloignée du substrat est à la distance mentionnée,
et/ou **en ce que** toute la surface de fond de la piste conductrice intermédiaire est à la distance mentionnée.

17. Circuit suivant l'une des revendications précédentes, **caractérisé en ce que** les structures conductrices d'une couche de structure conductrice au sein de cette couche de structure conductrice ont une hauteur, qui modifie de moins de vingt pour-cent ou de moins dix pour-cent la hauteur maximum de cette couche de structure conductrice.

18. Procédé de production d'un circuit intégré,
comprenant un substrat (20), dans lequel sont disposés une pluralité de composants intégrés à semiconducteurs,
comprenant une piste (58) conductrice de câblage proche du substrat, une piste (68) conductrice de câblage intermédiaire et une piste (76) conductrice de câblage éloignée du substrat, qui sont disposées dans cet ordre à une distance croissante du substrat (20),
les pistes (58, 68, 76) conductrices de câblage comprenant, respectivement, une surface plane de fond et une surface plane de recouvrement, qui sont voisines d'un diélectrique,
la surface de fond de la piste (76) conductrice de câblage éloignée du substrat s'étend dans un plan, dans lequel s'étend aussi la surface de recouvrement de la piste (68) conductrice de câblage intermédiaire ou la surface de fond de la piste (76) conductrice de câblage éloignée du substrat s'étend dans un plan, qui est plus proche du substrat (20) qu'un plan dans lequel s'étend la surface de recouvrement de la piste (68) conductrice de câblage intermédiaire, et
la surface de fond de la piste (68) conductrice de câblage intermédiaire s'étend dans un plan, dans lequel s'étend aussi la surface de recouvrement de la piste (58) conductrice de câblage proche du substrat ou la surface de fond de la piste (68) conductrice de câblage intermédiaire s'étend dans un plan, qui est plus proche du substrat (20) qu'un plan dans lequel s'étend la surface de recouvrement de la piste (68) conductrice de câblage proche du substrat,
dans lequel sont disposés une pluralité de composants intégrés à semiconducteurs,
comprenant une piste (58) conductrice de câblage proche du substrat, une piste (68) conductrice de câblage intermédiaire et une piste (76) conductrice de câblage éloignée du substrat, qui sont disposées dans cet ordre à une distance croissante du substrat (20),
les pistes (58, 68, 76) conductrices de câblage comprenant, respectivement, une surface plane de fond et une surface plane de recouvrement, qui sont voisines d'un diélectrique,
la surface de fond de la piste (76) conductrice de câblage éloignée du substrat s'étend dans un plan, dans lequel s'étend aussi la surface de recouvrement de la piste (68) conductrice de câblage intermédiaire ou la surface de fond de la piste (76) conductrice de câblage éloignée du substrat s'étend dans un plan, qui est plus proche du substrat (20) qu'un plan dans lequel s'étend la surface de recouvrement de la piste (68) conductrice de câblage intermédiaire, et
la surface de fond de la piste (68) conductrice de câblage intermédiaire s'étend dans un plan, dans lequel s'étend aussi la surface de recouvrement de la piste (58) conductrice de câblage proche du substrat ou la surface de fond de la piste (68) conductrice de câblage intermédiaire s'étend dans un plan, qui est plus proche du substrat (20) qu'un plan dans lequel s'étend la surface de recouvrement de la piste (68) conductrice de câblage proche du substrat,
dans lequel les pistes (58, 68, 76) de câblage ont respectivement un segment (AB1, AB2) médian, qui n'est pas voisin de traversées et de pistes conductrices,
**caractérisé en ce que** soit a) des pistes conductrices sont produites respectivement par un procédé damascène simple,
soit en variante b), la piste conductrice éloignée du substrat est structurée par un procédé soustractif, notamment par attaque ionique réactive,
et **en ce que** la piste conductrice intermédiaire ou la piste conductrice proche du substrat est structurée par un procédé damascène, **caractérisé par le fait que** la surface de fond de la piste conductrice de câblage éloignée du substrat est à une distance maximum d'un plan dans lequel s'étend la surface de recouvrement de la piste conductrice de câblage intermédiaire, qui représente moins de vingt pour-cent de la hauteur de la piste conductrice de câblage éloignée du substrat.
